# EUROPÄISCHE PATENTANMELDUNG

(11) **EP 4 064 106 A1**
(43) Veröffentlichungstag der Anmeldung: **28.09.2022**
(21) Anmeldenummer: 21163933.1
(22) Anmeldetag: 22.03.2021
(51) Int. Cl.: G06F 30/27, G06N 3/04

(54) **VERFAHREN ZUM ERZEUGEN VON TRAININGSDATEN FÜR EIN ML-MODELL**

(71) Anmelder: Siemens Aktiengesellschaft, 80333 München (DE)
(72) Erfinder: Gross, Ralf, 90471 Nürnberg (DE); Thon, Ingo, 85630 Grasbrunn (DE)

(57) **Zusammenfassung**

Die vorliegende Erfindung betrifft ein Verfahren zum Erzeugen von Trainingsdaten für ein ML-Modell (142, 162),
wobei die Trainingsdaten zum Einrichten des ML-Modells (142, 162) unter Verwendung eines maschinellen Lernverfahrens ausgebildet und eingerichtet sind,
und wobei insbesondere das ML-Modell (142, 162) zur Verwendung im Rahmen eines Verfahrens zum Ermitteln von Steuerungsdaten für eine Greifeinrichtung (120, 122) zum Greifen eines Gegenstands (200, 210, 220, 300, 310) ausgebildet und eingerichtet ist,
gekennzeichnet durch die Verfahrensschritte:
- Auswahl eines Gegenstands (200, 210, 220, 300, 310),
- Auswahl von Startdaten des Gegenstands (200, 210, 220, 300, 310) oberhalb einer ebenen Fläche (112),
- Erzeugen einer Fallbewegung des Gegenstands (200, 210, 220, 300, 310) in Richtung der ebenen Fläche (112) beginnend mit der Startdaten,
- Erfassen eines Bilds (132) des Gegenstands (200, 210, 220, 300, 310), nachdem eine Bewegung des Gegenstands (200, 210, 220, 300, 310) auf der ebenen Fläche (112) zum Stillstand gekommen ist,
- Zuordnung einer Kennung zu dem erfassten Bild (132), wobei die Kennung eine ID-Information für eine vom Gegenstand (200, 210, 220, 300, 310) eingenommene stabile Lage umfasst,
- Speicherung der Trainingsdaten umfassend das erfasste Bild sowie die diesem zugeordnete Kennung.

## Beschreibung

Die vorliegende Erfindung betrifft ein Verfahren zum Erzeugen von Trainingsdaten für ein ML-Modell,
wobei die Trainingsdaten zum Einrichten des ML-Modells unter Verwendung eines maschinellen Lernverfahrens ausgebildet und eingerichtet sind,
und wobei insbesondere das ML-Modell zur Verwendung im Rahmen eines Verfahrens zum Ermitteln von Steuerungsdaten für eine Greifeinrichtung ausgebildet und eingerichtet ist.

Derartige Verfahren sind aus dem Stand der Technik bekannt. So offenbart z.B. die Offenlegungsschrift US 2020/0164531 A1 beispielsweise ein System zum Greifen von Gegenständen, welches eine Erkennungs-Einrichtung zum Erkennen der Identität, eines Ortes und einer Ausrichtung eines Objektes umfasst sowie ein Auswahlsystem zum Auswählen einer Greifstelle für ein jeweiliges Objekt. Die Greifstelle kann beispielsweise von einem Nutzer ausgewählt werden. Weiterhin kann mit diesen von Nutzern ausgewählten Greifstellen das System unter Verwendung eines maschinellen Lernverfahrens mit der Zeit die besten Greifstellen eines Objektes lernen.

Es ist ein Nachteil des Standes der Technik, dass die Bestimmung der Greifstellen zum Greifen eines beliebigen Objektes jeweils letztendlich von einem Nutzer vorgenommen werden muss. Dies ist zum einen zeitlich sehr aufwendig, zum zweiten ist dies fehlerbehaftet, weil die Einschätzung des Nutzers auch fehlerhaft sein kann.

Daher ist es eine Aufgabe der vorliegenden Erfindung, ein Verfahren oder System zur Verfügung zu stellen, welches ein vereinfachtes Greifen eines Gegenstands ermöglicht. Ein solches Verfahren oder System kann dabei gegenüber dem Stand der Technik beispielsweise ein sichereres, zuverlässigeres, schnelleres und/oder höher automatisiertes Greifen ermöglichen.

Diese Aufgabe wird gelöst durch Verfahren mit den Merkmalen des Patentanspruch 1.

Ein solches Verfahren ist zum Erzeugen von Trainingsdaten für ein ML-Modell ausgebildet und eingerichtet,
wobei die Trainingsdaten zum Einrichten des ML-Modells unter Verwendung eines maschinellen Lernverfahrens ausgebildet und eingerichtet sind,
das Verfahren gekennzeichnet durch die Verfahrensschritte:
- Auswahl eines Gegenstands,
- Auswahl von Startdaten des Gegenstands oberhalb einer ebenen Fläche,
- Erzeugen einer Fallbewegung des Gegenstands in Richtung der ebenen Fläche (112) beginnend mit der Startdaten,
- Erfassen eines Bilds des Gegenstands, nachdem eine Bewegung des Gegenstands auf der ebenen Fläche zum Stillstand gekommen ist,
- Zuordnung einer Kennung zu dem erfassten Bild, wobei die Kennung eine ID-Information für eine vom Gegenstand eingenommene stabile Lage umfasst,
- Speicherung der Trainingsdaten umfassend das erfasste Bild sowie die diesem zugeordnete Kennung.

Dabei ist in einer vorteilhaften Ausgestaltung das ML-Modell zur Verwendung im Rahmen eines Verfahrens zum Ermitteln von Steuerungsdaten für eine Greifeinrichtung zum Greifen eines Gegenstands ausgebildet und eingerichtet.

Die Verwendung eines mit diesen Trainingsdaten trainierten ML-Modells ermöglicht es, ein Verfahren oder System zur Verfügung zu stellen, welches ein vereinfachtes Greifen eines Gegenstands erlaubt. Wie bereits im Rahmen der vorliegenden Beschreibung erläutert, führt die Beschränkung der berücksichtigten möglichen Lagen eines Gegenstands auf stabile Lagen gemäß der vorliegenden Beschreibung dazu, das vermittels eines so ausgebildeten Systems oder Verfahrens ein schnelleres, zuverlässigeres und/oder höher automatisiertes Greifen ermöglicht wird.

In einer vorteilhaften Ausgestaltung wird das genannte Verfahren mehrfach ausgeführt - z.B. jeweils mit unterschiedlichen Startdaten für den Gegenstand. Auf diese Weise kann eine größere Anzahl von Bildern mit zugeordneter Kennung zum Training des ML-Modells erzeugt werden. Dabei kann das Verfahren beispielsweise so häufig wiederholt werden, dass mehrere - vorteilhafter Weise auch alle - der möglichen stabilen Lagen des Gegenstands auf der ebenen Fläche auf mindestens einem der Bilder dargestellt sind. In einer weiteren vorteilhaften Ausgestaltung kann das Verfahren beispielsweise so häufig wiederholt werden, dass möglichst viele - vorteilhafter Weise auch alle - der möglichen stabilen Lagen des Gegenstands auf der ebenen Fläche auf mindestens zwei der Bilder oder mindestens zehn der Bilder dargestellt sind.

Ein Gegenstand kann dabei jedes dreidimensionale Gebilde mit einer festen äußeren Raumform sein. Gegenstände können beispielsweise Materialstücke, Bauteile, Module, Geräte oder Ähnliches sein.

Eine Greifeinrichtung kann beispielsweise als ein Roboter oder Roboter-Arm mit einem entsprechenden Greifer zum Fassen bzw. mechanischen Fixieren des Gegenstands ausgebildet und eingerichtet sein. Solch ein Greifer kann beispielsweise zangenartig ausgebildet sein, ein oder mehrere AnsaugEinrichtungen aufweisen und/oder ein Fixieren eines zu greifenden Gegenstands mit elektromagnetischen Kräften erlauben oder unterstützen.

Ein Roboter oder Roboter-Arm kann beispielsweise als ein 6-Achs-Roboter oder 6-Achs-Industrieroboter bzw. -Roboterarm ausgebildet und eingerichtet sein. Weiterhin kann ein solcher Roboter oder Roboter-Arm beispielsweise als Kartesischer Roboter oder mit einem entsprechenden Greifer ausgebildet und eingerichtet sein.

Die Steuerungsdaten für die Greifeinrichtung zum Greifen des Gegenstands an dem mindestens einen Greifpunkt sind dabei solche Daten, die einer Steuereinrichtung der Greifeinrichtung bzw. einer Steuereinrichtung für die Greifeinrichtung zugeführt werden müssen, damit beispielsweise ein Greifer der Greifeinrichtung den erfassten Gegenstand an dem mindestens einen Greifpunkt mechanisch fixiert. Solch eine Steuereinrichtung für die Greifeinrichtung kann beispielsweise als ein sogenannter Roboter-Controller, eine speicherprogrammierbare Steuerung, ein Computer oder eine ähnliche Steuereinrichtung ausgebildet und eingerichtet sein.

Dabei können die Steuerungsdaten beispielsweise die Koordinaten eines Punktes im Raum für den Greifer sowie eine Ausrichtung des Greifers umfassen, welche der Greifer einnehmen muss, um den Gegenstand greifen zu können. Weiterhin können die Steuerungsdaten auch die Koordinaten des mindestens einen Greifpunkts des Gegenstands im Raum sein bzw. diese Koordinaten umfassen.

Die Steuereinrichtung für die Greifeinrichtung kann unter Verwendung dieser Informationen dann auf bekannte Weise die nötige Bewegung der Greifeinrichtung sowie des Greifers berechnen.

Dabei wird unter Koordinaten im Raum hier beispielsweise ein Koordinatensystem verstanden, in welchem sich sowohl der zu greifende Gegenstand also auch die Greifeinrichtung befindet.

Steuerungsdaten können dann beispielsweise in diesen realen Raum transformierte Koordinaten des mindestens einen Greifpunkts und/oder des mindestens einen Modell-Greifpunkts sein. Weiterhin kann bei der Berechnung der Steuerungsdaten, neben den Koordinaten des mindestens einen Greifpunkts, auch eine Position des Gegenstands im Raum berücksichtigt werden, um beispielsweise einen ungehinderten Zugang eines Greifers der Greifeinrichtung zum mindestens einen Greifpunkt zu ermöglichen.

Das Erfassen des Bilds des Gegenstands kann beispielsweise vermittels einer Kamera, eines Scanners (beispielsweise eines Laserscanners), eines Abstandsradars oder einer ähnlichen Einrichtung zum Erfassen von dreidimensionalen Gegenständen erfolgen. Das erfasste Bild kann vorteilhafterweise ein zweidimensionales Bild des Gegenstands sein bzw. ein zweidimensionales Bild sein, welches ein Abbild des Gegenstands umfasst. Weiterhin kann das erfasste Bild auch eine dreidimensionale Darstellung des Gegenstands sein bzw. eine solche umfassen.

Dabei kann eine ID-Information eine eindeutige Bezeichnung, Kennung oder ähnliches für eine von einem Gegenstand eingenommene stabile Lage sein oder eine derartige Information umfassen.

Unter stabilen Lagen eines Gegenstands, beispielsweise auf einer Fläche (z.B. einer im wesentlichen horizontalen Ebene oder Fläche), werden diejenigen ein oder mehreren Lagen des Gegenstands bezeichnet, in welchen der Gegenstand sich befinden kann, ohne sich von selbst aus der Ruhe heraus zu bewegen (z.B. zu kippen oder zu rollen).

Solch eine stabile Lagen für den Gegenstand kann beispielsweise ermittelt werden, indem dieser mit einer Anfangsbewegung z.B. der Fläche zugeführt wird (z.B. auf diese Fläche fallengelassen wird) und dann abgewartet wird, bis der Gegenstand sich nicht mehr bewegt. Durch mehrfaches Ausführen dieses Vorgangs mit verschiedenen Anfangsbedingungen können auf diese Weise die stabilen Lagen eines Gegenstands bestimmt werden. Dabei kann z.B. der Gegenstand unter den verschiedensten Anfangsbedingungen auf eine entsprechende Fläche bewegt werden (z.B. darauf geworfen oder darauf fallengelassen). Dann wird abgewartet, bis sich der Gegenstand nicht mehr bewegt. Nachfolgend wird dann die eingenommene stabile Lage entsprechend erfasst.

Die Erfassung, Festlegung und/oder Speicherung einer stabilen Lage kann beispielsweise erfolgen, indem die eingenommene Lage registriert wird. Diese Registrierung kann z.B. über eine Bild-Aufnahme, eine 3D-Aufnahme und/oder eine Erfassung von einer oder mehrerer Koordinaten des Gegenstands in der stabilen Lage erfolgen. Weiterhin kann die Erfassung der stabilen Lage auch die Zuordnung einer für die stabile Lage des Gegenstands eindeutigen Kennung umfassen.

Dabei sind alle diejenigen erfassten Lage-Daten für einen bestimmten Gegenstand einer bestimmten stabilen Lage zuzuordnen, die durch eine Verschiebung und/oder eine Rotation um eine Oberflächennormale der Auflagefläche, auf welcher der Gegenstand liegt, ineinander überführbar sind. Allen diesen Lagen kann dann z.B. eine bestimmte Kennung für die zugehörige stabile Lage zugewiesen werden.

Die Ermittlung von stabilen Lagen eines Gegenstands kann dabei beispielsweise teilautomatisiert erfolgen, indem von einem Benutzer ein bestimmter Gegenstand ausgewählt wird und dann beispielsweise unter verschiedensten Anfangsbedingungen auf eine Fläche fallen gelassen wird oder dorthin geworfen wird. Nachfolgend wird gewartet, bis der Gegenstand zur Ruhe gekommen ist. Dann wird ein Bild des Gegenstands erfasst und vermittels eines automatischen Bildanalyseverfahrens überprüft, ob die Lage des erfassten Gegenstands durch eine Verschiebung und/oder Rotation um eine oberflächennormale der Fläche in eine bereits erfasste Lage des Gegenstands transformierbar ist. Wenn das der Fall ist, dann wird automatisch die Kennungen für diese stabile Lage auch dem jetzt aufgenommenen Bild zugeordnet.

Lässt sich die nun erfasste Lage des Gegenstands nicht entsprechend in die Lage eines bereits erfassten Gegenstands bzw. Gegenstands-Bilds transformieren, so wird dem jetzt aufgenommenen Bild eine neue Kennung für die darauf eingenommene stabile Lage des Gegenstands zugeordnet. Diese letzten Schritte können dann automatisiert erfolgen.

In einer weiteren Ausgestaltung kann die Ermittlung beispielsweise auch automatisiert erfolgen. Dies kann vorgenommen werden, indem beispielsweise eine physikalische Simulation einer Fallbewegung eines 3D-Modells eines Gegenstands auf eine Fläche herangezogen wird. Im Rahmen dieser Simulation wird dann abgewartet, bis die Bewegung des 3D-Modells des Gegenstands zur Ruhe gekommen ist. Dann wird ein entsprechendes Bild des nunmehr ruhenden 3D-Modells des Gegenstands aufgenommen und dem Bild gemäß dem vorstehend bereits erläuterten Verfahren eine Kennung für eine stabile Lage zugeordnet. Dieser Vorgang kann nun automatisch mit zufällig ausgewählten Anfangsbedingungen so lange wiederholt werden, bis keine neuen stabilen Lagen mehr gefunden werden bzw. für jede der gefundenen stabilen Lage eine ausreichende Menge an Bildern vorliegt.

Eine ausreichende Menge von Bildern kann beispielsweise gegeben sein, wenn 2, 10 oder auch 50 Bilder für jede stabile Lage vorliegen. Weiterhin kann festgelegt werden, dass eine neue stabile Lage dann nicht mehr gefunden wird, wenn nach 10,50 oder auch 100 Versuchen keine neue stabile Lage mehr gefunden wird.

Es können beispielsweise weiterhin die einer bestimmten stabilen Lage zugeordneten Bilder in einer Datenbank entsprechend abgespeichert werden. Diese Datenbank kann dann beispielsweise genützt werden, um einem neu erfassten Gegenstand durch Vergleich mit diesen Bildern eine bestimmte stabile Lage zuzuordnen.

Weiterhin können die Bilder herangezogen werden, um damit ein entsprechendes neuronales Netz oder ein anderes ML-Modell zu trainieren, welches dann im Rahmen der Bildauswertung für neu aufgenommene Bilder von Gegenständen verwendet werden kann. Unter Verwendung eines solchen Neuronalen Netzes oder ML-Modells kann dann beispielsweise ein aufgenommenes Bild eines ruhenden Gegenstands auf einer Fläche dem neuronalen Netz zugeführt werden. Das Ergebnis der Auswertung durch das neuronale Netz oder ML-Modell kann dann zumindest unter anderem eine Kennung für die von diesem Gegenstand eingenommene stabile Lage sein.

Ein Vorteil der Verwendung der stabilen Lagen im Rahmen eines Verfahrens gemäß der vorliegenden Beschreibung ist z.B., dass bei der Identifizierung, Positionsbestimmung und/oder Bestimmung des Greifpunkts nur die im Vergleich zu allen möglichen Lagen relativ wenigen stabilen Lagen berücksichtigt werden müssen. Dies kann den Rechenaufwand bei der Positionsbestimmung, Identifizierung und/oder Bestimmung des Greifpunkts reduzieren, häufig sogar erheblich reduzieren.

Unter einem maschinellen Lernverfahren wird beispielsweise ein automatisiertes ("maschinelles") Verfahren verstanden, welches Ergebnisse nicht durch im Vorhinein festgelegte Regeln generiert, sondern bei welchem vermittels eines maschinellen Lernalgorithmus oder Lernverfahrens aus vielen Beispielen (automatisch) Regelmäßigkeiten identifiziert werden auf deren Basis dann Aussagen über zu analysierende Daten erzeugt werden.

Solche maschinellen Lernverfahren können beispielsweise als ein überwachtes Lernverfahren, ein teilüberwachtes Lernverfahren, ein unüberwachtes Lernverfahren oder auch ein bestärkendes Lernverfahren ("Reinforcement Learning") ausgebildet und eingerichtet sein.

Beispiele für maschinelle Lernverfahren sind z.B. Regressions-Algorithmen (z.B. lineare Regressionsalgorithmen), eine Erzeugung oder Optimierung von Entscheidungsbäumen (sogenannte "Decision Trees"), Lernverfahren bzw. Trainingsverfahren für neuronale Netze, Clustering-Verfahren (z.B. ein sogenanntes "k-means-Clustering"), Lernverfahren für oder Erzeugung von Stützvektormaschinen ("Support Vector Machines" (SVM)), Lernverfahren für oder Erzeugung von sequentiellen Entscheidungsmodellen oder Lernverfahren für oder Erzeugung von Bayessche Modellen oder Netzen.

Das Ergebnis einer solchen Anwendung eines solchen maschinellen Lernalgorithmus oder Lernverfahrens auf bestimmte Daten wird, insbesondere in der vorliegenden Beschreibung, als "Machine-Learning"-Modell oder ML-Modell bezeichnet. Ein solches ML-Modell stellt dabei das digital gespeicherte oder speicherbare Ergebnis der Anwendung des maschinellen Lernalgorithmus oder Lernverfahrens auf die analysierten Daten dar.

Dabei kann die Erzeugung des ML-Modells derart ausgebildet und eingerichtet sein, dass das ML-Modell durch die Anwendung des maschinellen Lernverfahrens neu gebildet wird oder ein bereits bestehendes ML-Modell durch die Anwendung des maschinellen Lernverfahrens verändert oder angepasst wird.

Beispiele für solche ML-Modelle sind Ergebnisse von Regressions-Algorithmen (z.B. eines linearen Regressions-Algorithmus), Neuronale Netze ("Neural Networks"), Entscheidungsbäume ("Decision Tree"), die Ergebnisse von Clustering-Verfahren (inklusive z.B. die erhaltenen Cluster oder Cluster-Kategorien, -Definitionen und/oder -Parameter), Stützvektormaschinen ("Support Vector Machines" (SVM)), Sequentielle Entscheidungsmodelle oder Bayessche Modelle oder Netze.

Neuronale Netze können dabei z.B. sogenannte "Deep Neural Networks", "Feed Forward Neural Networks", "Recurrent Neural Networks"; "Convolutional Neural Networks" oder "Autoencoder-Neural-Networks" sein. Dabei wird die Anwendung entsprechender maschineller Lernverfahren auf neuronale Netze häufig auch als "Training" des entsprechenden Neuronalen Netzes bezeichnet.

Entscheidungsbäume können beispielsweise als sogenannte "iterative Dichotomizer 3" (ID3), Klassifikations- oder Regressionsbäume (CART) oder auch sogenannte "Random Forests" ausgebildet und eingerichtet sein.

Unter einem neuronalen Netz wird, zumindest im Zusammenhang mit der vorliegenden Beschreibung, eine elektronische Einrichtung verstanden, welche ein Netzwerk sogenannter Knoten umfasst, wobei in der Regel jeder Knoten mit mehreren anderen Knoten verbunden ist. Die Knoten werden beispielsweise auch als Neuronen, Units oder Einheiten bezeichnet. Dabei hat jeder Knoten mindestens eine Eingangs- und eine Ausgangsverbindung. Als Eingangs-Knoten für ein neuronales Netz werden solche Knoten verstanden, welche von der Außenwelt Signale (Daten, Reize, Muster oder ähnliches) empfangen können. Unter Ausgabe-Knoten eines neuronalen Netzes werden solche Knoten verstanden, welche Signale, Daten oder ähnliches an die Außenwelt weitergeben können. Unter sogenannten "versteckten Knoten" ("hidden nodes") werden solche Knoten eines neuronalen Netzes verstanden, welche weder als Eingangs- noch als Ausgangs-Knoten ausgebildet sind.

Neuronale Netze und auch andere ML-Modelle gemäß der vorliegenden Beschreibung können z.B. als eine Computersoftware und/oder eine Datensammlung realisiert sein, die auf einem Rechner, einem Rechner-Netzwerk oder einer Cloud speicherbar oder gespeichert sind.

Dabei kann das neuronale Netz beispielsweise als ein sogenanntes tiefes neuronales Netz ("deep neural network" (DNN)) ausgebildet sein. Ein solches "deep neural network" ist ein neuronales Netz, in welchem die Netzknoten in Schichten angeordnet sind (wobei die Schichten selbst ein-, zwei- oder auch höher-dimensional sein können). Ein tiefes neuronales Netz umfasst dabei mindestens eine oder zwei sogenannte verdeckte Schichten, welche nur Knoten umfassen, die nicht Eingangsknoten oder Ausgangsknoten sind. Das heißt, die verdeckten Schichten haben keine Verbindungen zu Eingangssignalen oder Ausgangssignalen.

Unter dem sogenannten "Deep Learning" wird dabei beispielsweise eine Klasse von maschinellen Lerntechniken verstanden, welche viele Schichten der nichtlinearen Informationsverarbeitung für die überwachte oder nicht-überwachte Merkmalsextraktion und -transformation sowie zur Musteranalyse und - klassifizierung ausnutzt.

Das Neuronale Netz kann beispielsweise auch eine sogenannte Auto-Encoder-Struktur aufweisen. Eine derartige Auto-Encoder-Struktur kann beispielsweise geeignet sein, um eine Dimensionalität der Daten zu reduzieren und beispielsweise so Ähnlichkeiten und Gemeinsamkeiten zu erkennen.

Ein Neuronales Netz kann beispielsweise auch als ein so genanntes Klassifizierungs-Netz ausgebildet sein, welches besonders dazu geeignet ist, Daten in Kategorien einzuteilen. Derartige Klassifizierungs-Netze werden beispielsweise in Zusammenhang mit Handschrift-Erkennung eingesetzt.

Eine weitere mögliche Struktur eines neuronalen Netzes kann beispielsweise die Ausgestaltung als so genanntes "Deep-Believe-Network" sein.

Ein neuronales Netz kann beispielsweise auch eine Kombination von mehreren der vorstehend genannten Strukturen aufweisen. So kann beispielsweise die Architektur des neuronalen Netzes eine Auto-Encoder-Struktur umfassen, um die Dimensionalität der Eingangsdaten zu reduzieren, welche dann weiterhin mit einer anderen Netzstruktur kombiniert werden kann, um beispielsweise Besonderheiten und/oder Anomalien innerhalb der datenreduzierten Dimensionalität zu erkennen bzw. die datenreduzierte Dimensionalität zu klassifizieren.

Die die einzelnen Knoten und deren Verbindungen beschreibenden Werte inklusive weiterer ein bestimmtes neuronales Netz beschreibende Werte können beispielsweise in einem das neuronale Netz beschreibenden Wertesatz gespeichert werden. Ein solcher Wertesatz stellt dann beispielsweise eine Ausgestaltung des neuronalen Netzes dar. Wird ein solcher Wertesatz nach einem Training des neuronalen Netzes gespeichert, so wird damit beispielsweise eine Ausgestaltung eines trainierten neuronalen Netzes gespeichert. So ist es beispielsweise möglich, in einem ersten Computersystem das neuronale Netz mit entsprechenden Trainingsdaten zu trainieren, den entsprechenden Wertesatz, welcher diesem neuronalen Netz zugeordnet ist, dann zu speichern und als Ausgestaltung des trainierten neuronalen Netzes in ein zweites System zu transferieren.

Ein neuronales Netz kann in der Regel trainiert werden, indem über verschiedenste bekannte Lernmethoden durch Eingabe von Eingangsdaten in das neuronale Netz und Analyse der dann entsprechenden Ausgangsdaten aus dem neuronalen Netz Parameterwerte für die einzelnen Knoten oder für deren Verbindungen ermittelt werden. Auf diese Weise kann ein neuronales Netz mit bekannten Daten, Mustern, Reizen oder Signalen auf an sich heute bekannte Weise trainiert werden, um das so trainierte Netz dann nachfolgend beispielsweise zur Analyse weiterer Daten verwenden zu können.

Allgemein wird unter dem Training des neuronalen Netzes verstanden, dass die Daten, mit welchen das neuronale Netz trainiert wird, im neuronalen Netz mithilfe eines oder mehrerer Trainings-Algorithmen verarbeitet werden, um so genannte Vorspannungswerte ("Bias"), Gewichtungswerte ("weights") und/oder Transferfunktionen ("Transfer Functions") der einzelnen Knoten des neuronalen Netzes bzw. der Verbindungen zwischen jeweils zwei Knoten innerhalb des neuronalen Netzes zu berechnen bzw. zu verändern.

Zum Training eines neuronalen Netzes, z.B. gemäß der vorliegenden Beschreibung, kann beispielsweise eine der Methoden des so genannten "überwachten Lernens" ("supervised learning") verwendet werden. Hierbei werden einem Netz durch Training mit entsprechenden Trainingsdaten diesen Daten jeweils zugeordnete Ergebnisse oder Fähigkeiten antrainiert. Solch ein Überwachtes-Lernverfahren kann beispielsweise eingesetzt werden, um einem neuronalen Netz beispielsweise die stabilen Lagen von einem oder mehreren Objekten anzutrainieren. Dies kann beispielsweise erfolgen, indem einem Bild eines Objekts, auf welchem sich das Objekt in einer stabilen Lage befindet, eine Kennung für die eingenommene stabile Lage (das o.g. "Ergebnis") "antrainiert" wird.

Weiterhin kann zum Training des neuronalen Netzes auch eine Methode des so genannten unüberwachten Trainings ("unsupervised learning") verwendet werden. Ein solcher Algorithmus erzeugt für eine gegebene Menge von Eingaben beispielsweise ein Modell, welches die Eingaben beschreibt und daraus Vorhersagen ermöglicht. Dabei gibt es beispielsweise Clustering-Verfahren, mit welchen sich die Daten in verschiedene Kategorien einteilen lassen, wenn sie sich beispielsweise durch charakteristische Muster voneinander unterscheiden.

Beim Trainieren eines neuronalen Netzes können auch überwachte und unüberwachte Lernmethoden kombiniert werden, beispielsweise wenn Teilen der Daten antrainierbare Eigenschaften oder Fähigkeiten zugeordnet sind, während dies bei einem anderen Teil der Daten nicht der Fall ist.

Weiterhin können auch noch Methoden des so genannten bestärkenden Lernens ("reinforcement learning") für das Training des neuronalen Netzes, zumindest unter anderem, verwendet werden.

Beispielsweise kann ein Training, welches eine relativ hohe Rechenleistung eines entsprechenden Computers erfordert, auf einem hochperformanten System geschehen, während weitere Arbeiten oder Datenanalysen mit dem trainierten neuronalen Netz dann durchaus auf einem niedriger-performanten System durchgeführt werden kann. Solche weiteren Arbeiten und/oder Datenanalysen mit dem trainierten neuronalen Netz können zum Beispiel auf einem Edge-Device und/oder auf einer Steuereinrichtung, einer Speicherprogrammierbaren Steuerung oder einer modularen Speicherprogrammierbaren Steuerung oder weiteren entsprechenden Einrichtungen gemäß der vorliegenden Beschreibung erfolgen.

Für das Training des ML-Modells mittels des maschinellen Lernverfahrens kann beispielsweise eine Sammlung von Bildern herangezogen werden, welche einen bestimmten Gegenstand in jeweils einer stabilen Lage auf einer ebenen Fläche zeigt, wobei jedem der Bilder eine Kennung für die darauf eingenommene stabile Lage zugeordnet ist. Das ML-Modell wird dann mit dieser Sammlung von Bildern trainiert. Dann kann nachfolgend die Bestimmung einer stabilen Lage dieses Gegenstands unter Anwendung des trainierten ML-Modells auf ein erfasstes Bild des Gegenstands erfolgen.

Bei der genannten Sammlung von Bildern kann beispielsweise jedes der Bilder Darstellung des Gegenstands in einer seiner stabilen Lagen auf einer gegebenen oder vorgebbaren Oberfläche zeigen, insbesondere auf einer ebenen Oberfläche oder auf einer im Wesentlichen horizontalen, ebenen Oberfläche. Die Sammlung von Bildern enthält dann z.B. eine Mehrzahl von Abbildungen des Gegenstands jeweils in einer seiner stabilen Lagen und weiterhin jeweils verschiedenen Rotationswinkeln gegenüber einer definierten oder definierbaren Ausgangslage auf einer Fläche sein. Die Rotation kann z.B. einer Oberflächennormalen einer Fläche definiert sein, auf welcher der Gegenstand in einer seiner stabilen Lagen liegt.

Das ML-Modell kann dabei beispielsweise als Neuronales Netz ausgebildet sein, wobei das maschinelle Lernverfahren in diesem Fall beispielsweise ein überwachtes Lernverfahren für neuronale Netze sein kann.

In einer weiteren vorteilhaften Ausgestaltung kann die zum Training des ML-Modells verwendete Sammlung von Bildern verschiedene Gegenstände in jeweils verschiedenen stabilen Lagen zeigen, wobei jedem der Bilder sowohl eine ID-Information bezüglich des abgebildeten Gegenstands als auch eine Kennung bezüglich der darauf eingenommenen stabilen Lage zugeordnet sein kann. Durch Anwendung eines mit einer solchen Sammlung von Bildern trainierten ML-Modells auf einen bestimmten erfassten Gegenstand ist dann Bestimmung sowohl einer ID-Information des Gegenstands als auch eine Kennung für die von diesem Gegenstand eingenommene stabile Lage ermittelbar.

Hierfür kann die Sammlung von Bildern beispielsweise so ausgestaltet und eingerichtet sein, dass jedes der Bilder Darstellung eines der Gegenstände in einer seiner stabilen Lagen auf einer gegebenen oder vorgebbaren Oberfläche zeigen, insbesondere auf einer ebenen Oberfläche oder auf einer im Wesentlichen horizontalen, ebenen Oberfläche. Die Sammlung von Bildern kann dann z.B. eine Mehrzahl von Abbildungen der verschiedenen Gegenstände jeweils in einer seiner stabilen Lagen und jeweils verschiedenen Rotationswinkeln gegenüber einer definierten oder definierbaren Ausgangslage enthalten. Die Rotation kann z.B. bezüglich einer Oberflächennormalen einer Fläche definiert sein, auf welcher der Gegenstand in einer seiner stabilen Lagen liegt.

Auch hier kann das ML-Modell beispielsweise als ein neuronales Netz ausgebildet sein, wobei das zugeordnete maschinelle Lernverfahren auch hier beispielsweise ein Verfahren des überwachten Lernens für neuronale Netze sein kann.

Das ML-Modell kann beispielsweise als ein sogenanntes "Erkennungs-ML-Modell" ausgebildet und eingerichtet sein. Ein solches Erkennungs-ML-Modell kann beispielsweise zur Erkennung eines Ortes des Gegenstands und/oder eines virtuellen Rahmens um den Gegenstand, eines Typs oder einer ID-Information bezüglich des Gegenstands und/oder einer stabilen Lage des Gegenstands ausgebildet und eingerichtet sein. Weiterhin kann ein ML-Modell gemäß der vorliegenden Beschreibung ein solches Erkennungs-ML-Modell umfassen. Ein solches Erkennungs-ML-Modell kann zum Beispiel als ein sogenanntes "Deep Neural Network" ausgebildet und eingerichtet sein. Als Eingabedaten für ein solches Erkennungs-ML-Modell kann beispielsweise das erfasste Bild des Gegenstands vorgesehen sein oder verwendet werden. Ausgabedaten eines solchen Erkennungs-ML-Modells können dann beispielsweise einer, mehrere oder alle der vorstehend genannten Parameter sein.

In einer weiteren Ausgestaltung kann das Erkennungs-ML-Modell weiterhin zur Erkennung eines Ortes, eines virtuellen Rahmens, eines Typs und/oder einer ID-Information jeweils zu mehreren oder allen auf einem erfassten Bild abgebildeten Gegenstände ausgebildet und eingerichtet sein. Ein derart ausgebildetes Erkennungs-ML-Modell kann vorteilhafterweise dann beispielsweise herangezogen werden, wenn sich auf dem erfassten Bild des Gegenstands weitere Gegenstände befinden.

Ausgabedaten eines derart ausgestalteten Erkennungs-ML-Modells können dann für jeden der erfassten Gegenstände beispielsweise die oben genannten Informationen bezüglich des Gegenstands sein: Daten bezüglich eines Orts und/oder virtuellen Rahmens und/oder eine ID-Information. Diese Informationen können dann beispielsweise in einem weiteren Verfahrensschritt dazu genützt werden, um den zu greifenden Gegenstand aus allen erfassten Gegenständen auszuwählen - beispielsweise anhand der ermittelten ID-Informationen. Die von diesem Erkennungs-ML-Modell dann bereits ermittelten Gegenstandsparameter können im Rahmen eines Verfahrens gemäß der vorliegenden Beschreibung dann verwendet werden, um die Steuerungsdaten für die Greifeinrichtung zum Greifen des Gegenstands zu ermitteln.

Weiterhin kann das ML-Modell beispielsweise als ein sogenanntes "Winkelerkennungs-ML-Modell" ausgebildet und eingerichtet sein, welches zumindest unter anderem zur Erkennung eines Rotationswinkels des Gegenstands auf einer Fläche bezüglich einer festgelegten oder festlegbaren Ausgangsposition ausgebildet und eingerichtet ist. Ein ML-Modell gemäß der vorliegenden Beschreibung kann auch ein solches Winkelerkennungs-ML-Modell umfassen. Ein derartiges Winkelerkennungs-ML-Modell kann beispielsweise als ein sogenanntes Regressions-AI-Modell oder auch ein sogenanntes Klassifizierung-AI-Modell ausgebildet und eingerichtet sein.

Als Eingabedaten für ein solches Winkelerkennungs-ML-Modell kann wiederum das erfasste Bild des Gegenstands verwendet werden. Ausgabedaten können dabei wiederum beispielsweise ein entsprechender Rotationswinkel des Gegenstands auf der Ablagefläche bezüglich einer festgelegten oder festlegbaren Ausgangsposition sein - oder einen solchen Rotationswinkel umfassen. Weiterhin können Ausgabedaten eines Winkelerkennungs-ML-Modells auch den vorstehend genannte Rotationswinkel umfassen, plus die Daten, die vorstehend beispielhaft aus Ausgabedaten eines Erkennungs-ML-Modells angegeben waren.

In einer weiteren Ausgestaltung kann das ML-Modell beispielsweise als ein sogenanntes "Transformations-ML-Modell" ausgebildet und eingerichtet sein, welches zur Ermittlung von Transformationsdaten von einer festgelegten oder festlegbaren Ausgangsposition des Gegenstands in die Position des erfassten Gegenstands auf der Ablagefläche in der realen Welt ausgebildet und eingerichtet ist. Eingabedaten für ein solches Transformation-ML-Modell können beispielsweise Kennungsdaten für den Gegenstand, eine stabile Lage des Gegenstands und/oder ein Rotationswinkel des Gegenstands auf der Ablagefläche bezüglich einer festgelegten oder festlegbaren Ausgangsposition sein. Kennungsdaten für den Gegenstand können dabei z.B. beispielsweise eine ID-Information, Beschreibungsdaten für einen virtuellen Rahmen um den Gegenstand, Informationen bezüglich einer stabilen Lage und/oder Skalierungsdaten sein.

Weiterhin können Eingabedaten für ein solches Transformation-ML-Modell auch erfasste Bilddaten eines auf einer ebenen Fläche liegenden Gegenstands sein. Die vorstehend genannten Eingabedaten, wie beispielsweise die Kennungsdaten für den Gegenstand, eine stabile Lage des Gegenstands und/oder ein Rotationswinkel des Gegenstands können dann beispielsweise aus diesen Bilddaten in einem ersten Schritt gewonnen werden wobei dann gemäß der vorstehenden Erläuterung weiter vorgegangen wird. Weiterhin können die genannten erfassten Bilddaten des auf der ebenen Fläche liegenden Gegenstands auch unmittelbar als Eingabedaten für ein entsprechendes Transformation-ML-Modell verwendet werden.

Ausgabedaten eines solchen Transformations-ML-Modells können dann beispielsweise Transformationsdaten für die vorstehend genannte Transformation des Gegenstands von der festgelegten oder festlegbaren Ausgangsposition in die reale Position des Gegenstands auf der Ablagefläche sein. Eine solche festgelegte oder festlegbare Ausgangsposition des Gegenstands kann beispielsweise die Position eines 3D-Modells des Gegenstands in einem entsprechenden 3D-Modellierungs-Programm (z. B. Einer 3D-CAD-Software) sein. Dies gilt beispielsweise auch für die in Bezug auf den Rotationswinkel verwendete Ausgangsposition.

Ein solches Transformations-ML-Modell kann beispielsweise als ein sogenanntes "Deep-Neural-Network" oder auch ein sogenanntes "Random Forest"-Modell ausgebildet und eingerichtet sein.

Ein ML-Modell gemäß der vorliegenden Beschreibung kann beispielsweise ein Erkennungs-ML Modell und/oder ein Winkelerkennungs-ML Modell und/oder ein Transformation-ML-Modell umfassen. Zudem kann ein weiteres ML-Modell gemäß der vorliegenden Beschreibung beispielsweise ein Erkennungs-ML Modell und/oder ein Winkelerkennungs-ML Modell und/oder ein Transformation-ML-Modell umfassen.

In einer vorteilhaften Ausgestaltung kann weiterhin ein ML-Modell gemäß der vorliegenden Beschreibung beispielsweise ein Erkennungs-ML-Modell und/oder ein Winkelerkennungs-ML-Modell umfassen bzw. ein solches ML-Modell ausgebildet und eingerichtet sein. Ein weiteres ML-Modell gemäß der vorliegenden Beschreibung kann in dieser Ausgestaltung beispielsweise ein Transformations-ML-Modell umfassen bzw. als ein solches Transformations-ML-Modell ausgebildet und eingerichtet sein.

Weiterhin können die Startdaten beispielsweise gegeben sein durch eine Höhe des Gegenstands, beispielsweise eines Schwerpunkts des Gegenstands, oberhalb der ebenen Fläche, einer Ausrichtung des Gegenstands im Raum sowie einem Vektor für eine Anfangsgeschwindigkeit des Gegenstands.

Die Fallbewegung kann beispielsweise eine Bewegung unter Einfluss der Gravitationskraft sein. Weiterhin können dabei weiterhin zusätzliche Kräfte, wie beispielsweise Reibungskräfte (z.B. in Luft oder in einer Flüssigkeit) sowie elektromagnetische Kräfte die Bewegung beeinflussen. In einer vorteilhaften Ausgestaltung wird die Bewegung beispielsweise durch die Gravitationskraft dominiert. Dabei beginnt die Fallbewegung entsprechend der Startdaten.

Dabei kann das ML-Modell beispielsweise als ein Erkennungs-ML-Modell gemäß der vorliegenden Beschreibung ausgebildet und eingerichtet sein oder ein solches umfassen. In diesem Fall kann die dem erfassten Bild zugeordnete Kennung neben der ID-Information für die vom Gegenstand eingenommene stabile Lage beispielsweise weitere Gegenstandsparameter gemäß der vorliegenden Beschreibung umfassen. Solche weiteren Gegenstandsparameter können dabei z.B. eine Information bezüglich einer Lage und/oder Position des Gegenstands, eine Information zu einer Lage und/oder Form eines virtuellen Rahmens um den Gegenstand, einen Typ des Gegenstands und/oder eine ID-Information bezüglich des Gegenstands umfassen.

Das ML-Modell kann beispielsweise auch als ein Winkelerkennungs-ML-Modell gemäß der vorliegenden Beschreibung ausgebildet und eingerichtet sein oder ein solches umfassen. In diesem Fall kann die dem erfassten Bild zugeordnete Kennung neben der ID-Information für die vom Gegenstand eingenommene stabile Lage beispielsweise weitere Gegenstandsparameter gemäß der vorliegenden Beschreibung umfassen. Solche weiteren Gegenstandsparameter können dabei z.B. einen Rotationswinkel des Gegenstands auf der ebenen Fläche bezüglich einer festgelegten oder festlegbaren Ausgangsposition umfassen.

Das ML-Modell kann weiterhin auch als ein Transformations-ML-Modell gemäß der vorliegenden Beschreibung ausgebildet und eingerichtet sein oder ein solches umfassen. In diesem Fall kann die dem erfassten Bild zugeordnete Kennung neben der ID-Information für die vom Gegenstand eingenommene stabile Lage beispielsweise weitere Gegenstandsparameter gemäß der vorliegenden Beschreibung umfassen. Solche weiteren Gegenstandsparameter können dabei z.B. Transformationsdaten für die vorstehend genannte Transformation des Gegenstands von der festgelegten oder festlegbaren Ausgangsposition in die reale Position des Gegenstands auf der ebenen Fläche umfassen. Auch hier kann eine solche festgelegte oder festlegbare Ausgangsposition des Gegenstands beispielsweise die Position eines 3D-Modells des Gegenstands in einem entsprechenden 3D-Modellierung-Programm (Z. B. Einer 3-D-CAD-Software) sein.

Die jeweils oben genannten Kennungs-Parameter und/oder Gegenstandsparameter können zumindest teilweise beispielsweise manuell durch einen Benutzer ermittelt werden - beispielsweise manuell durch eine Messung oder auch mithilfe eines zumindest teilautomatisierten Messystems. Weiterhin können solche Kennungsparameter zumindest teilweise automatisch beispielsweise durch Bildauswerte-Verfahren oder auch zusätzliche automatisehe Messysteme, wie z.B. ein optisches Messsystem, ein Laser-Messsystem und/oder ein akustisches Messsystem, ermittelt werden.

In einer weiteren vorteilhaften Ausgestaltung kann ein Verfahren zum Erzeugen von Trainingsdaten für ein Transformations-ML-Modell durch die nachfolgenden Verfahrensschritte ausgebildet und eingerichtet sein:
- Auswahl eines Gegenstands,
- Auswahl von Startdaten des Gegenstands oberhalb einer ebenen Fläche,
- Erzeugen einer Fallbewegung des Gegenstands in Richtung der ebenen Fläche,
- Erfassen eines Bilds des Gegenstands, nachdem die Bewegung des Gegenstands auf der ebenen Fläche zum Stillstand gekommen ist,
- Ermitteln mindestens eines Gegenstandsparameters bezüglich des Gegenstands unter Verwendung des erfassten Bilds, wobei der mindestens eine Gegenstandsparameter Kennungsdaten für den Gegenstand, eine Lage oder Position des Gegenstands, Informationen bezüglich eines virtuellen Rahmens um den Gegenstand, eine Kennung für eine stabile Lage des Gegenstands und/oder einen Rotationswinkel des Gegenstands auf der ebenen Fläche umfasst,
- Zuordnen einer Kennung zu dem ermittelten mindestens einen Gegenstandsparameter, wobei die Kennung Transformationsdaten für eine Transformation des Gegenstands von einer festgelegten oder festlegbaren Ausgangsposition in eine reale Position des Gegenstands auf der ebenen Fläche umfasst.

Dabei wird die reale Position des Gegenstands beispielsweise durch die Kennungsdaten für den Gegenstand, die Lage oder Position des Gegenstands, die Informationen bezüglich eines virtuellen Rahmens um den Gegenstand, die Kennung für eine stabile Lage des Gegenstands und/oder einen Rotationswinkel des Gegenstands beschrieben.

Dabei können Kennungsdaten für den Gegenstand beispielsweise eine ID-Information, Beschreibungsdaten für einen virtuellen Rahmen um den Gegenstand, eine ID-Information bezüglich einer stabilen Lage und/oder Skalierungsdaten sein oder umfassen.

Die Transformationsdaten, die festgelegte oder festlegbare Ausgangsposition, der Rotationswinkel des Gegenstands, die Kennung für eine stabile Lage des Gegenstands sowie der mindestens eine Gegenstandsparameter kann dabei gemäß der vorliegenden Beschreibung ausgebildet und eingerichtet sein. Weiterhin können auch die Lage oder Position des Gegenstands und/oder die Informationen bezüglich eines virtuellen Rahmens um den Gegenstand gemäß der vorliegenden Beschreibung ausgebildet und eingerichtet sein.

Die vorstehend genannte Aufgabe wird ebenfalls gelöst durch ein Verfahren zum Erzeugen von Trainingsdaten für ein ML-Modell,
wobei die Trainingsdaten zum Einrichten des ML-Modells unter Verwendung eines maschinellen Lernverfahrens ausgebildet und eingerichtet sind,
das Verfahren gekennzeichnet durch die Verfahrensschritte:
- Auswahl eines 3D-Modells eines Gegenstands,
- Auswahl von Startdaten des 3D-Modells des Gegenstands oberhalb einer virtuellen ebenen Fläche,
- Simulieren einer Fallbewegung des 3D-Modells des Gegenstands in Richtung der virtuellen ebenen Fläche,
- Erstellen eines Bilds des 3D-Modells des Gegenstands, nachdem die simulierte Bewegung des 3D-Modells des Gegenstands auf der virtuellen ebenen Fläche zur Ruhe gekommen ist,
- Zuordnung einer Kennung zu dem erstellten Bild, wobei die Kennung eine ID-Information für die vom 3D-Modell des Gegenstands eingenommene stabile Lage umfasst,
- Speicherung der Trainingsdaten umfassend das erfasste Bild sowie die diesem zugeordnete Kennung.

Dabei kann ein solches Verfahren gemäß der vorliegenden Beschreibung ausgebildet und eingerichtet sein.

Weiterhin kann das Verfahren derart ausgestaltet sein, dass das ML-Modell zur Verwendung im Rahmen eines Verfahrens zum Ermitteln von Steuerungsdaten für eine Greifeinrichtung zum Greifen eines Gegenstands ausgebildet und eingerichtet ist.

Die Speicherung der Trainingsdaten kann dabei in einer Speichereinrichtung und/oder beispielsweise in einer Datenbank oder Datensammlung für entsprechende Trainingsdaten erfolgen.

Dabei kann das ML-Modell beispielsweise gemäß der vorliegenden Beschreibung ausgebildet und eingerichtet sein. Weiterhin können das maschinelle Lernverfahren, die Steuerungsdaten, die Greifeinrichtung, der Gegenstand, die Startdaten, die Kennung, und die stabile Lage gemäß der vorliegenden Beschreibung ausgebildet und eingerichtet sein.

Wie bereits im Zusammenhang mit dem vorausgehend beschriebenen Verfahren erläutert, ermöglicht es die Verwendung eines mit diesen Trainingsdaten trainierten ML-Modells, ein Verfahren oder System zur Verfügung zu stellen, welches ein vereinfachtes Greifen eines Gegenstands erlaubt.

Ein 3D-Modell kann jede digitale Darstellung oder Repräsentation des Gegenstands sein, die zumindest die äußere Form im Wesentlichen repräsentiert. Vorteilhafterweise repräsentiert das 3D-Modell die äußere Form des Gegenstands. Weiterhin kann das 3D-Modell auch Informationen über den inneren Aufbau des Gegenstands, Beweglichkeiten von Komponenten des Gegenstands oder auch Informationen über Funktionalitäten des Gegenstands enthalten.

Das 3D-Modell kann z.B. in einem 3D-Dateiformat gespeichert sein beispielsweise mit einem 3D-CAD-Software Tool erstellt worden sein. Beispiele für solche Software Tools sind beispielsweise SolidWorks (Dateiformat: .sldprt), Autodesk Inventor (Dateiformat: .ipt), AutoCAD (Dateiformat: .dwg), PTC ProE/Creo (Dateiformat: .prt), CATIA (Dateiformat: .catpart), SpaceClaim (Dateiformat: .scdoc) oder SketchUp (Dateiformat: .skp). Weitere Dateiformate können beispielsweise sein: .blend (Blender-Datei), .dxf (Drawing Interchange Format), .igs (Initial Graphics Exchange Specification), .stl (Stereolithografieformat), .stp (Standard for the Exchange of Product Model Data), .sat (ACIS-Textdatei) oder .wrl, .wrz (Virtual Reality Modeling Language). Vorteilhafter Weise können Dateiformate verwendet werden, bei welcher Materialeigenschaften des Gegenstands wie z.B. spezifisches Gewicht, Farbe, Material und/oder ähnliches des Gegenstands oder seiner Komponenten mitgespeichert sind. Durch Verwendung solcher 3D-Modelle lassen sich z.B. physikalisch korrekte Simulationen für den Gegenstand durchführen, z.B. zur Bestimmung einer oder mehrerer stabiler Lagen des Gegenstands auf einer Oberfläche.

Das Auswählen des 3D-Modells für den Gegenstand kann beispielsweise unter Verwendung einer ID-Information für den Gegenstand erfolgen, wobei der mindestens eine Gegenstandsparameter diese ID-Information umfasst.

Dabei kann Das 3D-Modell beispielsweise einer Datenbank für 3D-Modelle verschiedener Gegenstände entnommen werden, wobei die Auswahl aus dieser Datenbank beispielsweise unter Verwendung der oben genannten ermittelten ID-Information erfolgen kann. Weiterhin kann die Auswahl des 3D-Modells alternativ auch durch einen Benutzer erfolgen. Dabei kann der Benutzer beispielsweise das 3D-Modell unter mehreren verfügbaren 3D-Modellen auswählen.

In einer vorteilhaften Ausgestaltung kann das genannte Verfahren mehrfach ausgeführt werden - z.B. jeweils mit unterschiedlichen Startdaten für den Gegenstand - um beispielsweise eine Mehrzahl von Bildern mit zugeordneter Kennung zum Training des ML-Modells zu erzeugen.

Dabei kann das Verfahren beispielsweise so häufig wiederholt werden, dass mehrere - vorteilhafter Weise auch alle - der möglichen stabilen Lagen des digitalen Modells des Gegenstands auf der virtuellen ebenen Fläche auf mindestens einem der Bilder dargestellt sind. In einer weiteren vorteilhaften Ausgestaltung kann das Verfahren beispielsweise so häufig wiederholt werden, dass möglichst viele - vorteilhafter Weise auch alle - der möglichen stabilen Lagen des digitalen Modells des Gegenstands auf der virtuellen ebenen Fläche auf mindestens zwei der Bilder oder mindestens zehn der Bilder dargestellt sind.

Dabei können auch hier das ML-Modell, der Gegenstand, das Erfassen des Bilds sowie die ID-Information für die vom Gegenstand eingenommene stabile Lage gemäß der vorliegenden Beschreibung ausgebildet und eingerichtet sein.

Die Startdaten können beispielsweise gegeben sein durch eine Höhe des Gegenstands (z.B. eine Höhe eines Schwerpunkts des Gegenstands) oberhalb der ebenen Fläche, einer Ausrichtung des Gegenstands im Raum sowie einem Vektor für eine Anfangsgeschwindigkeit des Gegenstands.

Die Fallbewegung kann beispielsweise als eine Bewegung unter Einfluss der Gravitationskraft simuliert werden. Weiterhin können dabei weiterhin zusätzliche Kräfte, wie beispielsweise Reibungskräfte (z.B. in Luft oder in einer Flüssigkeit) sowie elektromagnetische Kräfte bei der Simulation berücksichtigt werden. In einer vorteilhaften Ausgestaltung wird die Bewegung beispielsweise nur unter Berücksichtigung der Gravitationskraft simuliert. Dabei beginnt die Simulation der Fallbewegung dann entsprechend der Startdaten.

Das ML-Modell kann beispielsweise als ein Erkennungs-ML-Modell gemäß der vorliegenden Beschreibung ausgebildet und eingerichtet sein oder ein solches umfassen. In diesem Fall kann die Kennung zu dem erstellten Bild neben der ID-Information für die vom 3D-Modells des Gegenstands eingenommene stabile Lage beispielsweise weitere Gegenstandsparameter gemäß der vorliegenden Beschreibung umfassen. Solche weiteren Gegenstandsparameter können dabei z.B. eine Information bezüglich eines einer Lage und/oder Position des 3D-Modells des Gegenstands, eine Information zu einer Lage und/oder Form eines virtuellen Rahmens um das 3D-Modells des Gegenstands, einen Typ des Gegenstands und/oder eine ID-Information bezüglich des Gegenstands umfassen.

Das ML-Modell kann beispielsweise auch als ein Winkelerkennungs-ML-Modell gemäß der vorliegenden Beschreibung ausgebildet und eingerichtet sein oder ein solches umfassen. In diesem Fall kann die dem erfassten Bild zugeordnete Kennung neben der ID-Information für die vom 3D-Modells des Gegenstands eingenommene stabile Lage beispielsweise weitere Gegenstandsparameter gemäß der vorliegenden Beschreibung umfassen. Solche weiteren Gegenstandsparameter können dabei z.B. einen Rotationswinkel des 3D-Modells des Gegenstands auf der virtuellen ebenen Fläche bezüglich einer festgelegten oder festlegbaren Ausgangsposition umfassen.

Das ML-Modell kann beispielsweise auch als ein Transformations-ML-Modell gemäß der vorliegenden Beschreibung ausgebildet und eingerichtet sein oder ein solches umfassen. In diesem Fall kann die dem erfassten Bild zugeordnete Kennung neben der ID-Information für die vom 3D-Modells des Gegenstands eingenommene stabile Lage beispielsweise weitere Gegenstandsparameter gemäß der vorliegenden Beschreibung umfassen. Solche weiteren Gegenstandsparameter können dabei z.B. Transformationsdaten für die vorstehend genannte Transformation des 3D-Modells des Gegenstands von einer festgelegten oder festlegbaren Ausgangsposition in eine reale Position des Gegenstands auf der Ablagefläche umfassen. Auch hier kann eine solche festgelegte oder festlegbare Ausgangsposition des 3D-Modells des Gegenstands beispielsweise die Position des 3D-Modells des Gegenstands in einem entsprechenden 3D-Modellierung-Programm (Z. B. Einer 3-D-CAD-Software) sein.

Die jeweils oben genannten Kennungs-Parameter und/oder Gegenstandsparameter können in einer vorteilhaften Ausgestaltung beispielsweise automatisch ermittelt werden. Da sämtliche Größendaten, Lagedaten und sonstige eine Lage und/oder Position beschreibende Daten des Gegenstands in der digitalen Simulationsumgebung bekannt sind, (ansonsten wäre eine Simulation des Gegenstands, insbesondere eine physikalische Simulation, nicht möglich) können eine Position des Gegenstands, eine Lage des Gegenstands, ein Rotationswinkel des Gegenstands bezüglich der virtuellen ebenen Fläche, Transformationsdaten gemäß der vorliegenden Beschreibung und weitere vergleichbare Gegenstandsparameter bezüglich des 3D-Modells des Gegenstands direkt den Simulationssystem entnommen werden. Daher ist es möglich, dass ein vorstehend beschriebenes Verfahren zum Erzeugen von Trainingsdaten unter Verwendung eines 3D-Modells des Gegenstands automatisch abläuft und so automatisch Trainingsdaten für ein ML-Modell gemäß der vorliegenden Beschreibung erzeugbar sind oder erzeugt werden.

Die jeweils oben genannten Kennungs-Parameter können aber auch zumindest teilweise manuell durch einen Benutzer ermittelt werden - beispielsweise manuell durch eine Messung oder auch mithilfe eines zumindest teilautomatisierten Messystems. Weiterhin können solche Kennungsparameter zumindest teilweise automatisch beispielsweise durch Bildauswerte-Verfahren oder auch zusätzliche automatische digitale Messysteme in einer Simulationsumgebung für die Durchführung des hier beschriebenen Verfahrens ermittelt werden.

In einer weiteren vorteilhaften Ausgestaltung kann ein Verfahren zum Erzeugen von Trainingsdaten für ein Transformation-ML-Modell durch die nachfolgenden Verfahrensschritte ausgebildet und eingerichtet sein:
- Auswahl eines 3D-Modells eines Gegenstands,
- Auswahl von Startdaten des 3D-Modells des Gegenstands oberhalb einer virtuellen ebenen Fläche,
- Simulieren einer Fallbewegung des 3D-Modells des Gegenstands (250, 350) in Richtung der virtuellen ebenen Fläche,
- Erstellen eines Bilds (132) des 3D-Modells des Gegenstands (250, 350), nachdem die simulierte Bewegung des 3D-Modells des Gegenstands (250, 350) auf der virtuellen ebenen Fläche zur Ruhe gekommen ist,
- Ermitteln mindestens eines Gegenstandsparameters bezüglich des 3D-Modells des Gegenstands unter Verwendung des erstellten Bilds, wobei der mindestens eine Gegenstandsparameter

Kennungsdaten für den Gegenstand, eine Lage oder Position des 3D-Modells des Gegenstands, Informationen bezüglich eines virtuellen Rahmens um das 3D-Modells des Gegenstands, eine Kennung für eine stabile Lage des 3D-Modells des Gegenstands und/oder einen Rotationswinkel des 3D-Modells des Gegenstands auf der virtuellen ebenen Fläche umfasst,
- Zuordnen einer Kennung zu dem ermittelten mindestens einen Gegenstandsparameter, wobei die Kennung Transformationsdaten für eine Transformation des 3D-Modells des Gegenstands von einer festgelegten oder festlegbaren Ausgangsposition in eine ermittelte Position des 3D-Modells des Gegenstands auf der virtuellen ebenen Fläche umfasst,
- Speicherung der Trainingsdaten umfassend den mindestens einen Gegenstandsparameter sowie die diesem zugeordnete Kennung.

Die Speicherung der Trainingsdaten kann dabei in einer Speichereinrichtung und/oder beispielsweise in einer Datenbank oder Datensammlung für entsprechende Trainingsdaten erfolgen.

Dabei wird die ermittelte Position des Gegenstands beispielsweise durch die Kennungsdaten für das 3D-Modell des Gegenstands, eine Lage oder Position des 3D-Modells des Gegenstands, eine Information bezüglich eines virtuellen Rahmens um das 3D-Modells des Gegenstands, die Kennung für eine stabile Lage des 3D-Modells des Gegenstands und/oder einen Rotationswinkel des 3D-Modells des Gegenstands beschrieben.

Dabei können Kennungsdaten für das 3D-Modells des Gegenstands beispielsweise eine ID-Information, Beschreibungsdaten für einen virtuellen Rahmen um das 3D-Modells des Gegenstands, eine ID-Information für eine stabile Lage und/oder Skalierungsdaten sein oder umfassen.

Die Transformationsdaten, die festgelegte oder festlegbare Ausgangsposition, der Rotationswinkel des 3D-Modells des Gegenstands, die ID-Information oder Kennung für eine stabile Lage des 3D-Modells des Gegenstands sowie der mindestens eine Gegenstandsparameter kann dabei gemäß der vorliegenden Beschreibung ausgebildet und eingerichtet sein. Weiterhin können auch die Lage oder Position des 3D-Modells des Gegenstands und/oder die Informationen bezüglich eines virtuellen Rahmens um das 3D-Modell des Gegenstands gemäß der vorliegenden Beschreibung ausgebildet und eingerichtet sein.

Der mindestens eine Gegenstandsparameter kann beispielsweise eine Kennung bezüglich des Gegenstands, eine ID-Information bezüglich des Gegenstands und/oder auch ein Name oder eine Kurzbeschreibung bzw. Beschreibung des Gegenstands sein oder umfassen. Dabei kann die Kennung beispielsweise derart ausgebildet und eingerichtet sein, dass sie ein Identifizieren des Gegenstands erlaubt. Dabei kann eine ID-Information eine eindeutige Bezeichnung, Kennung oder ähnliches für den jeweiligen Gegenstand sein oder derartige Informationen umfassen.

Weiterhin kann der mindestens eine Gegenstandsparameter beispielsweise eine Lage, Position o.ä. bezüglich des erfassten Gegenstands umfassen. Eine solche Lage kann beispielsweise durch charakteristische Punkte und die Lage der charakteristischen Punkte gegeben sein und/oder beispielsweise auch durch eine Lage oder Position eines virtuellen Begrenzungsrahmens auf dem erfassten Bild, einer sogenannten "Bounding Box", definiert sein. Weiterhin oder zusätzlich kann eine solche Lage oder Position beispielsweise auch durch die Lage eines zentralen Punktes des Gegenstands (Z. B. eines Schwerpunkts) und eines Rotationswinkels gegenüber einer definierten oder definierbaren Standard-Lage gegeben sein.

Weiterhin kann der mindestens eine Gegenstandsparameter auch eine Eigenschaft des Gegenstands, wie beispielsweise eine Farbe, ein Material oder eine Materialkombination oder vergleichbare Eigenschaften, umfassen.

Die Bestimmung des mindestens einen Gegenstandsparameters für den erfassten Gegenstand bezieht sich dabei auf den auf dem erfassten Bild dargestellten Gegenstand. Der mindestens eine Gegenstandsparameter ist daher dem auf dem erfassten Bild dargestellten Gegenstand zugeordnet, so wie er auf dem erfassten Bild dargestellt ist.

Die vorstehend genannte Aufgabe wird weiterhin gelöst durch ein Verfahren zum Erzeugen von Trainingsdaten für ein ML-Modell,
gekennzeichnet durch die Verfahrensschritte:
- Auswahl eines 3D-Modells eines Gegenstands,
- Auswahl einer virtuellen ebenen Fläche,
- Bestimmung einer Lage des 3D-Modells des Gegenstands derart, dass das 3D-Modell des Gegenstands die virtuelle ebene Fläche in drei oder mehr Punkten berührt,
- Erstellen eines Bilds des digitalen Modells des Gegenstands,
- Zuordnung einer Kennung zu dem Bild, wobei die Kennung eine ID-Information für die vom 3D-Modell des Gegenstands die eingenommene stabile Lage umfasst,
- Speicherung der Trainingsdaten umfassend das erstellte Bild sowie die diesem zugeordnete Kennung.

Die Speicherung der Trainingsdaten kann dabei in einer Speichereinrichtung und/oder beispielsweise in einer Datenbank oder Datensammlung für entsprechende Trainingsdaten erfolgen. Dabei kann das ML-Modell beispielsweise gemäß der vorliegenden Beschreibung ausgebildet und eingerichtet sein. Weiterhin kann das beschriebene Verfahren zum Erzeugen von Trainingsdaten für ein ML-Modell gemäß der vorliegenden Beschreibung ausgebildet und eingerichtet sein.

In einer vorteilhaften Ausgestaltung kann das genannte Verfahren auch hier mehrfach ausgeführt, um beispielsweise eine möglichst große Anzahl von Bildern mit zugeordneter Kennung zum Training des ML-Modells zu erzeugen. Dabei kann das Verfahren beispielsweise so häufig wiederholt werden, dass mehrere - vorteilhafter Weise auch alle - der möglichen stabilen Lagen des digitalen Modells des Gegenstands auf der virtuellen ebenen Fläche auf mindestens einem der Bilder dargestellt sind. In einer weiteren vorteilhaften Ausgestaltung kann das Verfahren beispielsweise so häufig wiederholt werden, dass möglichst viele - vorteilhafter Weise auch alle - der möglichen stabilen Lagen des digitalen Modells des Gegenstands auf der virtuellen ebenen Fläche auf mindestens zwei der Bilder oder mindestens zehn der Bilder dargestellt sind.

Die vorstehend genannten Verfahren zum Erzeugen von Trainingsdaten können weiterhin derart fortgebildet werden, dass die jeweiligen Verfahren weiterhin jeweils zum Training eines ML-Modells gemäß der vorliegenden Beschreibung, oder zum Training eines weiteren ML-Modells gemäß der vorliegenden Beschreibung, derart ausgebildet und eingerichtet ist,
dass das ML-Modell oder das weitere ML-Modell unter Verwendung des erfassten oder ermittelten Bilds und zumindest der diesem zugeordneten ID-Information für die vom Gegenstand oder die vom 3D-Modell des Gegenstands eingenommene stabile Lage trainiert wird.

Dabei kann das ML-Modell und/oder das weitere ML-Modell beispielsweise als ein Erkennungs-ML-Modell und/oder ein Winkelerkennungs-ML-Modell und/oder ein Transformation-ML-Modell ausgebildet und eingerichtet sein bzw. derartige ML-Modelle umfassen. Das ML-Modell und/oder das weitere ML-Modell kann also die Funktion von einem, zwei oder auch allen drei der genannten ML-Modelle umfassen.

In einer weiteren Ausgestaltung kann das ML-Modell beispielsweise als ein Erkennungs-ML-Modell und/oder ein Winkelerkennungs-ML-Modell ausgebildet und eingerichtet sein, während das weitere ML-Modell beispielsweise als ein Transformation-ML-Modell ausgebildet und eingerichtet sein kann.

In einer vorteilhaften Ausgestaltung kann das Verfahren beispielsweise zum Training eines Erkennungs-ML-Modells gemäß der vorliegenden Beschreibung, eines Winkelerkennungs-ML-Modells gemäß der vorliegenden Beschreibung und/oder eines Transformation-ML-Modells gemäß der vorliegenden Beschreibung verwendet werden.

Das Training des ML-Modells und/oder des weiteren ML-Modells kann dabei weiterhin beispielsweise unter Verwendung des erfassten Bilds des Gegenstands, einer Position des Gegenstands, einer ID-Information des Gegenstands, eines Rotationswinkels des Gegenstands und/oder einer Kennung bezüglich einer vom Gegenstand eingenommenen stabilen Lage erfolgen. Dabei werden zum Training des ML-Modells und/oder des weiteren ML-Modells dabei beispielsweise die Position des Gegenstands, die ID-Information des Gegenstands, der Rotationswinkel des Gegenstands und/oder die Kennung bezüglich der vom Gegenstand eingenommenen stabilen Lage dem erfassten Bild des Gegenstands zugeordnet. Eine solche Zuordnung von Parametern - hier zum erfassten Bild - wird ganz allgemein auch als sogenanntes "Labelling" bezeichnet.

Zum Training eines als Erkennungs-ML-Modell ausgebildeten ML Modells kann das erfasste Bild beispielsweise mit einer Position des Gegenstands, einer ID-Information des Gegenstands und/oder einer Kennung bezüglich einer vom Gegenstand eingenommenen stabilen Lage gelabelt werden.

Weiterhin kann zum Training eines als Rotationserkennungs-ML-Modells ausgebildeten ML-Modells beispielsweise das erfasste Bild des Gegenstands mit einer Position des Gegenstands, einer ID Information des Gegenstands, eines Rotationswinkel des Gegenstands und/oder einer Kennung bezüglich einer vom Gegenstand eingenommenen stabilen Lage gelabelt werden.

Zum Training eines als Transformation-ML-Modells ausgebildeten ML-Modells kann das erfasste Bild beispielsweise mit entsprechenden Transformationsdaten zur Transformation einer Ausgangs Lage des Gegenstands in die auf dem erfassten Bild eingenommene Lage gelabelt werden.

Weiterhin kann zum Training eines als Transformation-ML-Modells ausgebildeten ML Modells mindestens ein unter Verwendung des erfassten oder erstellten Bilds ermittelter Gegenstandsparameter gemäß der vorliegenden Beschreibung beispielsweise mit entsprechenden Transformationsdaten zur Transformation einer Ausgangslage des Gegenstands in die auf dem erfassten oder erstellten Bild eingenommene Lage gelabelt werden.

Die vorstehend genannte Aufgabe wird weiterhin gelöst durch die Verwendung von vermittels eines Verfahrens zum Erzeugen von Trainingsdaten gemäß der vorliegenden Beschreibung erzeugten Trainingsdaten zum Einrichten eines ML-Modells, insbesondere eines ML-Modells gemäß der vorliegenden Beschreibung.

Weiterhin wird die vorstehend genannte Aufgabe ebenfalls gelöst durch ein ML-Modell gemäß der vorliegenden Beschreibung, wobei das ML-Modell unter Verwendung von gemäß der vorliegenden Beschreibung erzeugten Trainingsdaten eingerichtet wurde.

Die vorstehend genannte Aufgabe wird weiterhin gelöst durch Verfahren zum Ermitteln von Steuerungsdaten für eine Greifeinrichtung unter Verwendung eines ML-Modells, welches mit gemäß der vorliegenden Beschreibung erzeugten Trainingsdaten eingerichtet wurde,
wobei das Verfahren zum Greifen eines Gegenstands ausgebildet und eingerichtet ist und die nachfolgenden Schritte umfasst:
- Erfassen eines Bilds des Gegenstands,
- Bestimmung mindestens eines Gegenstandsparameters für den erfassten Gegenstand,
- Ermittlung von Steuerungsdaten für eine Greifeinrichtung zum Greifen des Gegenstands an mindestens einem Greifpunkt, wobei weiterhin das Ermitteln des mindestens einen Greifpunkts des Gegenstands unter Verwendung des ML-Modells erfolgt.
insbesondere, dass die Bestimmung des mindestens einen Gegenstandsparameters und/oder die Ermittlung der Steuerungsdaten für die Greifeinrichtung unter Verwendung des ML-Modells erfolgt.

Dabei kann das ML-Modell beispielsweise gemäß der vorliegenden Beschreibung ausgebildet und eingerichtet sein.

Dabei können beispielsweise der Gegenstand, das Erfassen eines Bildes des Gegenstands, sowie der mindestens eine Gegenstandsparameter gemäß der vorliegenden Beschreibung ausgebildet und eingerichtet sein.

In einer vorteilhaften Ausgestaltung des Verfahrens kann dabei vorgesehen sein, dass im Rahmen des Ermittelns des mindestens einen Greifpunkts des Gegenstands eine Analyse des erfassten Bildes des Gegenstands unter Verwendung des ML-Modells erfolgt. Insbesondere kann vorgesehen sein, dass im Rahmen der Bestimmung des mindestens einen Gegenstandsparameters und/oder im Rahmen der Ermittlung der Steuerungsdaten für die Greifeinrichtung eine Analyse des erfassten Bildes des Gegenstands unter Verwendung des ML-Modells erfolgt.

Da im Rahmen der Einrichtung des ML-Modells Trainingsdaten gemäß der vorliegenden Beschreibung verwendet wurden, erfolgt die genannte Analyse unter Verwendung von Informationen über mindestens eine stabile Lage der betrachteten Gegenstände.

Der vorstehend genannten Ausgestaltung liegt die Erkenntnis zugrunde, dass bei der Analyse des Bilds des Gegenstands beispielsweise zur Identifikation des Gegenstands oder der Bestimmung weiterer Gegenstandsparameter, nicht sämtliche möglichen Ausrichtung des Gegenstands berücksichtigt werden müssen sondern davon ausgegangen werden kann, dass der Gegenstand sich in einer möglichen stabilen Lage befindet. Dies schränkt die Zahl der Möglichkeiten für die möglichen Lagen des Gegenstands bei der entsprechenden Bildanalyse erheblich ein. Auf diese Weise können entsprechende Analyseverfahren zur Identifizierung des Gegenstands und/oder der Bestimmung seiner Lage einfacher und/oder schneller ablaufen. Damit wird die daraus folgende Ermittlung eines entsprechenden Greifpunkts für diesen Gegenstand ebenfalls gegenüber dem Stand der Technik weiter vereinfacht.

Weiterhin lässt sich auch das Ermitteln des mindestens einen Greifpunkts des Gegenstands leichter, schneller/oder effizienter durchführen, wenn im Rahmen der Ermittlung des mindestens einen Greifpunkts Informationen bezüglich mindestens einer möglichen stabilen Lage des Gegenstands herangezogen werden. Dies kann z.B. durch die Analyse des erfassten Bildes eines Gegenstands unter Verwendung eines ML-Modells gemäß der vorliegenden Beschreibung realisiert sein. Dabei erlaubt die Beschränkung der von für die Bildanalyse herangezogenen Algorithmen auf mögliche stabile Lagen des Gegenstands eine deutliche Reduktion des Analyseaufwands, da ein Großteil von möglichen Lagen des Gegenstands dabei außer Acht bleiben kann.

Informationen bezüglich mindestens einer möglichen stabilen Lage eines Gegenstands können z.B. als ein ML-Modell ("Machine-Learning"-Modell) gemäß der vorliegenden Beschreibung ausgebildet und eingerichtet sein. Dabei wurde das ML-Modell z.B. vermittels der Anwendung eines maschinellen Lernverfahrens auf ermittelte Informationen bezüglich der mindestens einen möglichen Stabilen Lage trainiert und/oder eingerichtet. Beispielsweise kann ein solches ML-Modell als ein neuronales Netz ausgebildet und eingerichtet sein.

Unter einer Verwendung von Informationen bezüglich der mindestens einen möglichen stabilen Lage des Gegenstands wird dabei jede Verwendung einer derartigen Information im Rahmen einer Berechnung oder Ermittlung von Daten oder Informationen verstanden. So stellt beispielsweise die Verwendung eines ML Modells gemäß der vorliegenden Beschreibung, welches unter Verwendung von Trainingsdaten gemäß der vorliegenden Beschreibung trainiert oder eingerichtet wurde, eine Verwendung von Informationen gemäß einer möglichen stabilen Lage eines Gegenstands dar.

So kann beispielsweise im Rahmen einer Identifikation eines Gegenstands, oder auch im Rahmen der Bestimmung einer Lage des Gegenstands, ein entsprechendes ML-Modell verwendet werden.

Auch die Auswahl eines 3D-Modells des Gegenstands kann in vergleichbarer Weise unter Verwendung eines ML-Modells gemäß der vorliegenden Beschreibung vorgenommen werden. Dabei kann beispielsweise vermittels einem der vorstehend erläuterten Verfahrensabläufe unter Verwendung des ML-Modells eine ID-Information des Gegenstands ermittelt werden und anhand dieser ID-Information dann ein entsprechendes 3D-Modell beispielsweise aus einer entsprechenden Datenbank ausgewählt werden.

Weiterhin kann auch sowohl die Bestimmung des mindestens einen Greifpunkts des Gegenstands als auch die Ermittlung von Steuerdaten für die Greifeinrichtungen gemäß der vorliegenden Beschreibung in vergleichbarer Weise unter Verwendung von des ML-Modells erfolgen.

So kann beispielsweise wiederum über das genannte ML-Modell der mindestens eine Gegenstandsparameter für den erfassten Gegenstand derart bestimmt werden, dass für den Gegenstand eine Kennung für seine stabile Lage, ein Abstandswinkel zu einem festgelegten Nullpunkt und/oder ein Drehwinkel bezüglich einer Oberflächennormale zur Ablagefläche des Gegenstands ermittelt wird. Aufgrund dieser Information können dann beispielsweise Transformationsdaten für eine Transformation eines 3D-Modells des Gegenstands inklusive eines gegebenenfalls dort festgelegten Modell-Greifpunkte in eine Lage des entsprechenden realen Gegenstands festgelegt werden. Mithilfe dieser Transformationsdaten kann dann z.B. der mindestens eine Greifpunkt des Gegenstands ermittelt werden. Auf vergleichbare Weise können dann auch die Steuerungsdaten für die Greifeinrichtung aus den Transformationsdaten und weiteren Informationen in Bezug auf beispielsweise eine Zugänglichkeit des Gegenstands ermittelt werden.

Die vorstehend genannte Aufgabe wird weiterhin gelöst durch ein System zum Greifen eines Gegenstands,
umfassend eine optische Erfassungseinrichtung zur Erfassung eines Bilds des Gegenstands,
eine Datenverarbeitungseinrichtung zum Bestimmen mindestens eines Gegenstandsparameters des Gegenstands und/oder zum Ermitteln von Steuerungsdaten für eine Greifeinrichtung zum Greifen des Gegenstands,
wobei das System ein ML-Modell umfasst, welches mit gemäß der vorliegenden Beschreibung erzeugten Trainingsdaten eingerichtet wurde, und wobei das System zur Durchführung eines Verfahrens zum Ermitteln von Steuerungsdaten für eine Greifeinrichtung gemäß der vorliegenden Beschreibung ausgebildet und eingerichtet ist.

In einer vorteilhaften Ausgestaltung kann die Datenverarbeitungseinrichtung beispielsweise das ML-Modell bzw. ein ML-Modell gemäß der vorliegenden Beschreibung umfassen. Beispielsweise kann die Datenverarbeitungseinrichtung als eine speicherprogrammierbare Steuerung ausgebildet und eingerichtet sein, wobei das ML-Modell beispielsweise in einem Zentralmodul der speicherprogrammierbaren Steuerung vorgesehen sein kann. Alternativ kann das ML-Modell auch in einem Funktionsmodul vorgesehen sein, welches über einen Rückwandbus der speicherprogrammierbaren Steuerung mit einem o.g. Zentralmodul der speicherprogrammierbaren Steuerung verbunden ist.

Zur Durchführung des Verfahrens kann die Datenverarbeitungseinrichtung beispielsweise eine entsprechende Ausführungsumgebungen umfassen, welche beispielsweise zum Ablauf einer Software ausgebildet und eingerichtet ist, bei deren Ablauf ein Verfahren gemäß der vorliegenden Beschreibung ausgeführt wird.

Dabei kann die Datenverarbeitungseinrichtung auch mehrere Komponenten oder Module (Z. B. umfassend ein oder mehrere Controller, Edge-Devices, SPS-Module, Computer und/oder vergleichbare Geräte) umfassen. Solche Komponenten oder Module können dann beispielsweise über eine entsprechende Kommunikationsverbindung, Z. B. Ein Ethernet, ein industrielles Ethernet, einen Feldbus, einen Rückwandbus und/oder vergleichbare Geräte verbunden sein. In einer weiteren Ausgestaltung kann diese Kommunikationsverbindung beispielsweise weiterhin zur Echtzeitkommunikation ausgebildet und eingerichtet sein.

In einer weiteren Ausgestaltung eines Systems gemäß der vorliegenden Beschreibung kann die Datenverarbeitungseinrichtung als eine modulare Speicherprogrammierbare Steuerung mit einem Zentralmodul und einem weiteren Modul ausgebildet und eingerichtet sein, oder eine solche Speicherprogrammierbare Steuerung umfassen,
wobei weiterhin das weitere Modul das ML-Modell umfasst.

Es kann weiterhin auch vorgesehen sein, dass die Datenverarbeitungseinrichtung eine modulare Speicherprogrammierbare Steuerung mit einem Zentralmodul und einem weiteren Modul umfasst,
und dass weiterhin die Bestimmung des mindestens einen Gegenstandsparameters des Gegenstands unter Verwendung des weiteren Moduls erfolgt.

Bei einer speicherprogrammierbaren Steuerung (SPS), handelt es sich um eine Steuerungseinrichtung, die programmiert und eingesetzt wird, um eine Anlage oder Maschine zu regeln bzw. zu steuern. In einer solchen SPS können spezifische Funktionen, wie beispielsweise eine Ablaufsteuerung, implementiert sein, so dass auf diese Weise sowohl die Eingangs- als auch die Ausgangssignale von Prozessen oder Maschinen gesteuert werden können. Definiert wird die speicherprogrammierbare Steuerung beispielsweise im Standard EN 61131.

Um eine speicherprogrammierbare Steuerung an eine Anlage bzw. Maschine anzubinden, kommen sowohl Aktoren der Anlage oder Maschine, die im Allgemeinen an den Ausgängen der speicherprogrammierbaren Steuerung angeschlossen sind, als auch Sensoren der Anlage oder Maschine zum Einsatz. Grundsätzlich befinden sich die Sensoren an den SPS-Eingängen, wobei durch sie die speicherprogrammierbare Steuerung Informationen darüber erhält, was in der Anlage bzw. Maschine vorgeht. Als Sensoren gelten beispielsweise: Lichtschranken, Endschalter, Taster, Inkrementalgeber, Füllstandsensoren, Temperaturfühler. Als Aktoren gelten z.B.: Schütze zum Einschalten elektrischer Motoren, elektrische Ventile für Druckluft oder Hydraulik, Antriebssteuerungsmodule, Motoren, Antriebe.

Die Realisierung eine SPS kann auf verschiedene Art und Weise erfolgen. Das heißt, sie kann als elektronisches Einzelgerät, als Softwareemulation, als sogenannte Soft-SPS (oder auch "virtuelle SPS" oder auch SPS-Applikation bzw. SPS-App genannt) als PC-Einsteckkarte usw. verwirklicht werden. Häufig finden sich auch modulare Lösungen, im Rahmen derer die SPS aus mehreren Steckmodulen zusammengebaut wird.

Eine modulare speicherprogrammierbare Steuerung kann dabei derart ausgebildet und eingerichtet sein, dass mehrere Module vorgesehen sein können oder sind, wobei in der Regel neben einem sogenannten Zentralmodul, das zum Ablauf eines Steuerprogramms z.B. zur Steuerung einer Komponente, Maschine oder Anlage (bzw. eines Teils davon) ausgebildet und eingerichtet ist, ein oder mehrere Erweiterungsmodule vorgesehen sein können. Solche Erweiterungsmodule können beispielsweise als eine Strom-/Spannungsversorgung ausgebildet und eingerichtet sein oder auch zur Ein- und/oder Ausgabe von Signalen bzw. Daten. Weiterhin kann ein Erweiterungsmodul auch als ein Funktionsmodul zur Übernahme spezieller Aufgaben (z.B. ein Zähler, ein Umrichter, Datenverarbeitung mit künstliche-Intelligenz-Methoden (umfasst z.B. ein Neuronales Netz oder ein sonstiges ML-Modell) ...) .

Beispielsweise kann ein Funktionsmodul auch als ein AI-Modul zur Ausführung von Aktionen unter Verwendung künstlicher Intelligenz-Verfahren ausgebildet und eingerichtet sein. Ein solches Funktionsmodul kann beispielsweise ein neuronales Netz oder das ML-Modell oder ein auch weiteres ML-Modell gemäß der vorliegenden Beschreibung umfassen.

Das weitere Modul, dass in der vorliegenden Ausgestaltung das ML-Modell umfasst, kann dann beispielsweise zur Durchführung spezieller Aufgaben im Rahmen der Durchführung des Verfahrens, z.B. rechenaufwendiger Teilaufgaben oder rechenaufwendiger Spezialaufgaben (wie beispielsweise einer Transformation, eine Anwendung von AI- oder ML-Methoden, o. ä.) vorgesehen sein. Dafür kann das weitere Modul beispielsweise speziell ausgebildet und eingerichtet sein und/oder auch eine weitere Programm-Ablaufumgebung für eine entsprechende Software umfassen.

Mit dieser Ausgestaltung wird das System zum Greifen des Gegenstands weiter vereinfacht, da die Datenverarbeitungseinrichtung speziell an eine vorgesehene Greifaufgabe angepasst werden kann. Insbesondere ist dies möglich, ohne einen zentralen Verfahrensablauf ändern zu müssen, welcher beispielsweise in einem Zentralmodul der speicherprogrammierbaren Steuerung ablaufen kann. Spezielle Teilaufgaben können dann im weiteren Modul ablaufen, welches dann je nach genauer Greifaufgabe unterschiedlich ausgestaltet und eingerichtet sein kann.

In einer weiteren Ausgestaltung eines Systems gemäß der vorliegenden Beschreibung kann die Datenverarbeitungseinrichtung ein Edge-Device umfassen, oder als ein Edge-Device ausgebildet und eingerichtet sein,
wobei weiterhin das Edge-Device das ML-Modell umfasst.

Dabei kann weiterhin vorgesehen sein, dass die Bestimmung des mindestens einen Gegenstandsparameters des Gegenstands unter Verwendung des Edge-Devices erfolgt.

Ein Edge-Device kann beispielsweise eine Applikation zur Steuerung von Vorrichtungen oder Anlagen umfassen und/oder auch eine Applikation zur Verarbeitung, Analyse und/oder Weiterleitung von Daten einer Steuerungseinrichtung für eine Vorrichtung oder Anlage bzw. Daten der Vorrichtung oder Anlage selbst. Beispielsweise kann eine solche Applikation als eine Applikation mit der Funktionalität einer speicherprogrammierbaren Steuerung ausgebildet und eingerichtet sein. Das EDGE Device kann dabei beispielsweise mit einer Steuereinrichtung einer Vorrichtung oder Anlage verbunden sein oder auch unmittelbar mit einer zu steuernden Vorrichtung oder Anlage. Weiterhin kann das EDGE Device derart ausgebildet und eingerichtet sein, dass es zusätzlich noch mit einem Datennetzwerk oder einer Cloud verbunden ist bzw. zur Verbindung mit einem entsprechenden Datennetzwerk oder einer entsprechenden Cloud ausgebildet und eingerichtet ist.

Ein Edge-Device kann weiterhin zur Realisierung zusätzlicher Funktionalitäten im Zusammenhang mit der Steuerung beispielsweiser einer Maschine, Anlage oder Komponente - oder Teilen davon - ausgebildet und eingerichtet sein. Solche zusätzlichen Funktionalitäten können z.B. sein:
- Daten sammeln und Übertragen in die Cloud, Vorverarbeitung, Kompression, Analyse;
- Analyse z.B. mit AI-Verfahren, z.B. mittels eines neuronalen Netzes oder eines anderen ML-Modells. Das Edge-Device kann dafür z.B. ein ML-Modell umfassen, z.B. ML-Modell gemäß der vorliegenden Beschreibung.

Da ein Edge-Device im Vergleich zu einer eher herkömmlichen industriellen Steuerungseinrichtung, wie beispielsweise einem Controller oder einer SPS, häufig eine höhere Rechenleistung aufweist, vereinfacht und/oder beschleunigt eine solche Ausgestaltung ein Verfahren gemäß der vorliegenden Beschreibung weiter. In einer möglichen Ausgestaltung kann dabei vorgesehen sein, dass ein Verfahren gemäß der vorliegenden Beschreibung vollständig auf einem solchen Edge-Device ausgeführt wird.

In einer alternativen Ausgestaltung kann auch vorgesehen sein, dass beispielsweise besonders rechenintensive und/oder aufwändige Verfahrensschritte auf dem Edge-Device ausgeführt werden, während andere Verfahrensschritte auf einer weiteren Komponente der Datenverarbeitungseinrichtung, beispielsweise einer Steuerung oder einer speicherprogrammierbaren Steuerung, ausgeführt werden. Solche rechenintensiven und/oder aufwändigen Verfahrensschritte können beispielsweise Verfahrensschritte unter Verwendung von Maschinen Learning Techniken oder künstlicher Intelligenz sein, wie beispielsweise die Anwendung eines oder mehrerer ML-Modelle gemäß der vorliegenden Beschreibung.

Ein derartiges System mit einem Edge-Device kann dabei weiterhin derart ausgebildet und eingerichtet sein, dass die Bestimmung des mindestens einen Gegenstandsparameters des Gegenstands unter Verwendung des ML-Modells erfolgt, wobei das Edge-Device das ML-Modell umfasst.

Weiterhin kann ein derartiges System mit einem Edge-Device auch derart ausgebildet und eingerichtet sein, dass das Ermitteln der Steuerungsdaten für die Greifeinrichtung unter Verwendung des ML-Modells erfolgt, wobei das Edge-Device das ML-Modell umfasst.

Weitere vorteilhafte Ausgestaltungen finden sich in den Unteransprüchen.

Nachfolgend wird eine exemplarische mögliche Ausgestaltung eines Verfahrens und/oder einer Vorrichtung gemäß der vorliegenden Beschreibung dargestellt.

Diesem Ausführungsbeispiel liegt das Problem zugrunde, dass in vielen Herstellungsprozessen Teile über sogenannte "Schütten" als Transportsystem zur Verfügung gestellt werden. Dabei können solche Teile beispielsweise von externen Zulieferern kommen oder auch aus einem vorgelagerten internen Produktionsprozess. Für den weiteren Herstellungsprozess ist es beispielsweise notwendig, dass diese Teile isoliert werden und einzeln in spezifischer Weise manipuliert oder transportiert werden. Speziell für Herstellungsverfahren, in welchen diese weitere Behandlung durch Roboter Arme erfolgt, ist eine genaue Information bezüglich der Lage und Orientierung der isolierten Teile notwendig. In derartigen Schütten ist allerdings die Lage und Position der Teile vollkommen zufällig und kann nicht auf eine vorgegebene Weise festgelegt werden. Daher müssen diese Daten dynamisch ermittelt werden um diese Teile beispielsweise mit einem Roboterarm erfolgreich greifen und transportieren zu können.

Ein beispielhaftes Verfahren und System zum Greifen eines Gegenstands gemäß der vorliegenden Beschreibung kann beispielsweise kann im Rahmen dieses Ausführungsbeispiels z.B. derart ausgestaltet und eingerichtet sein, dass das System Objekte oder Teile lokalisieren kann, für welche ein 3D-Modell des Objekts bzw. Teils verfügbar ist. Ein solches 3D-Modell kann beispielsweise von einer 3D-CAD-Software erstellt worden sein. Ein solches Verfahren kann beispielsweise auf verschiedenen Hardwaregeräten ausgeführt werden, beispielsweise einer speicherprogrammierbaren Steuerung, einer modularen speicherprogrammierbaren Steuerung, einem EDGE-Device oder auch unter Verwendung von Rechenkapazität in einer Cloud, beispielsweise um die entsprechende Bildverarbeitung zu machen. Eine speicherprogrammierbare Steuerung kann dabei beispielsweise derart ausgestaltet sein, dass Verfahrensschritte unter Verwendung von künstlicher Intelligenz oder maschinellen Lerntechniken in einem speziellen Funktionsmodul für die speicherprogrammierbare Steuerung zur Durchführung von künstliche-Intelligenz-Methoden durchgeführt werden. Solche Module können beispielsweise ein neuronales Netz umfassen.

Das beispielhafte im folgenden beschriebene System kann die 6D-Orientierung beliebiger Gegenstände z.B. unter Verwendung eines entsprechenden 3D-Modells des Gegenstands erkennen, so dass der Gegenstand zuverlässig an einem im 3D-Modell spezifizierten Greifpunkt gegriffen werden kann. Dies erlaubt dem System entsprechende Zuführ-Teile mit hoher wiederholbarer Genauigkeit beispielsweise einem bestimmten Produktionsschritt zuzuführen.

Ein genereller Aufbau eines Systems zur Durchführung eines derartigen Verfahrens kann beispielsweise die nachfolgend genannten Komponenten umfassen:
a.) Ein Transportsystem für zu verarbeitende Teile mit einer ebenen Oberfläche, optional mit einer Vibrations-Trennungseinrichtung;
b.) Ein Roboterarm zum Greifen der zu verarbeitenden Teile;
c.) Eine Kamera zur Erfassung von Bilddaten von den zu verarbeitenden Teilen auf dem Transportsystem für einen entsprechenden Kamera-Controller;
d.) Eine speicherprogrammierbare Steuerung (PLC) um jeweils Greifkoordinaten der Zuführteile zur Verfügung zu stellen und an den Roboter zu übermitteln;
e.) Einen Kameracontroller zur Identifikation der Teile (Klassifikation), zur Bestimmung von deren Orientierung (Detektion/Segmentierung) und zur Ermittlung der Greifkoordinaten.

Damit kann ein derartiges beispielhaftes System beispielsweise umfassen: die PLC, den Kameracontroller, die Kamera, eine Software, die auf den jeweiligen Komponenten abläuft, sowie eine weitere Software, welche Eingangswerte für die genannte Software erzeugt.

Nach dem Erfassen eines Bilds mit mehreren Teilen ist das beispielhaft beschriebene System dazu ausgebildet und eingerichtet, die Teile zu erkennen, dann ein bestimmtes zu greifendes Teil auszuwählen und die Greifpunkte für dieses zu greifende Teil zu bestimmen. Zu diesem Zweck führt die Software und die weitere Software zur beispielsweise die nachfolgenden Schritte aus:
1.) Bild-Segmentierung: In einem ersten Schritt wird das Bild unter Verwendung eines AI-Modells ("M-Seg") segmentiert. Dieses Segmentierungs AI-Modell M-Seg ist dabei ein Beispiel für ein Erkennungs-ML-Modell gemäß der vorliegenden Beschreibung. Dabei wird angenommen, dass jedes der Teile isoliert betrachtet wird, als ob es individuell bzw. einzelnen auf der Ablagefläche bzw. der Zuführeinrichtung liegen würde. Danach wird zu jedem der Teile ein rechteckiger virtueller Begrenzungsrahmen (Ort in X, Y) ermittelt, ein Typ des Objekts bestimmt sowie eine Position/Skalierung in X, Y Richtung berechnet. Dabei entspricht die Position der ungefähren Orientierung in der Rotation-Dimension des 6D Raums, basieren auf den möglichen stabilen Lagen der Teile, wie sie nachfolgend erläutert werden. Das ausgewählte Teil, insbesondere beispielsweise der zugeordnete virtuelle Begrenzungsrahmen, definiert dann die "Region of Interest" (ROI), auf welchen die nachfolgenden Schritte angewendet werden.
2.) In einem weiteren, optionalen Schritt wird der Rotationswinkel des ausgewählten Teils in Bezug auf die Ablagefläche berechnet. Dies wird mit einem sogenannten Regressions- und/oder Klassifizierungs-AI-Modells ("M-RotEst") durchgeführt. M-RotEst ist dabei für ein Beispiel für ein Winkelerkennungs-ML-Modell gemäß der vorliegenden Beschreibung.
3.) In einem nächsten Schritt wird ein drittes AI-Modell ("M(Teile-ID, eingenommene stabile Lage, Rotationswinkel)") auf die ROI angewandt, in welcher sich das ausgewählte Teil befindet. Dabei werden die bereits in den vorhergehenden

Schritten bestimmten Größen: Typ des Teils (Teile-ID), eingenommene stabile Lage, sowie der ermittelte Rotationswinkel des Teils als Eingangsgrößen verwendet. Für dieses dritte AI-Modell kann beispielsweise ein "Deep-Neural-Network", ein "Random Forest"-Modell oder ein vergleichbares ML-Modell verwendet werden. Weiterhin wird ein 3D-Modell des ausgewählten Teils beispielsweise aus einer entsprechenden Datenbank ausgewählt. In einem weiteren Schritt wird dann ein Bildauswerteverfahren, wie beispielsweise SURF, SIFT oder BRISK auf die ROI angewendet. Dabei werden die erkannten Merkmale des 3D-Modells des ausgewählten Teils sowie auf dem erfassten Bild des Teils abgeglichen. Dieser letztgenannte Schritt ergibt dabei die Transformationsdaten zwischen dem 3D-Modell des ausgewählten Teils und dem ausgewählten Teil auf dem erfassten Kamerabild in der Realität. Diese Transformationsdaten können dann dazu verwendet werden, um im 3D-Modell gekennzeichnete Greifpunkte in den realen Raum derart zu transformieren, dass dann die Koordinaten der Greifpunkte für das ausgewählte Teil zur Verfügung stehen. Dieses dritte AI Modell M(Teile-ID, eingenommene stabile Lage, Rotationswinkel) ist dabei ein Beispiel für ein Transformations-ML-Modell gemäß der vorliegenden Beschreibung.

Nachfolgend wird beschrieben, wie die vorstehend genannte Software bzw. die genannten ML-Modelle (z.B. M-Seg, M-RotEst und M(Teile-ID, eingenommene stabile Lage, Rotationswinkel)) zur Durchführung des beschriebenen Verfahrens eingerichtet bzw. trainiert werden können.

Dafür wird als ein Input ein 3D-Modell des zu greifenden Teils zur Verfügung gestellt, wobei im 3D-Modell mögliche Greifpunkte für das Teil spezifiziert bzw. gekennzeichnet sind.

Weiterhin werden dann in einem ersten Schritt mögliche stabile Lagen des Teils auf einer ebenen Fläche bestimmt. Dabei ist eine derartige mögliche stabile Lage eine Lage, in welcher sich das Objekt im Gleichgewicht befindet und nicht umkippt. Bei einer Münze ist dies beispielsweise auch eine Lage, bei welcher die Münze auf dem Rand steht.

Diese möglichen stabilen Lagen können beispielsweise ermittelt werden, indem die Gegenstände mit verschiedensten Anfangsbedingungen auf eine ebene Fläche fallen gelassen werden. Dies kann in der Realität erfolgen oder auch in einer entsprechenden physikalischen Simulation unter Verwendung eines 3D-Modells des Teils. Dann wird sowohl in der Simulation als auch in der Realität abgewartet, bis das Teil sich nicht mehr bewegt. Die dann erreichte Position wird als eine stabile Lage betrachtet, und als solche erfasst. Eine weitere Option zur Ermittlung möglicher stabiler Lagen ist eine Ermittlung von denjenigen Positionen, in welchen das ausgewählte Teil eine ebene Fläche in (mindestens) drei Punkten berührt, wobei das Objekt dann die Fläche in keinem anderen Punkt durchdringt. Den auf eine der beschriebenen Weisen ermittelten stabilen Lagen wird dann jeweils eine eindeutige Kennung zugeordnet.

Nachfolgend werden dann Trainingsdaten für das Segmentierungs-ML-Modell (M-Seg) erzeugt. Die Trainingsdaten bestehen dabei aus einem Satz von Bildern mit erfassten Gegenständen, annotiert bzw. gelabelt mit dem jeweiligen Ort des Gegenstands, einer ID-Information oder einem Typ des Gegenstands, sowie einer entsprechend eingenommenen stabilen Lage. Diese Daten können beispielsweise erzeugt werden, indem in der realen Welt verschiedene Objekte in entsprechenden stabilen Lagen positioniert werden. Alternativ können 3D-Modelle der Objekte auch in einer Raytracer-Software oder Spiele-Engine in jeweils stabilen Positionen virtuell angeordnet werden, wobei dann dann nachfolgend entsprechende Bilder dieser Gegenstände künstlich erzeugt werden.

Danach werden Label für die entsprechenden Bilder der Objekte erzeugt. Das Label für jedes der Objekte besteht aus einem rechteckigen virtuellen Begrenzungsrahmens (xl, y1, x2, y2), den Objekttyp sowie einer Kennung für die eingenommene stabile Lage.

Wenn das optionale Winkelerkennungsmodell M-RotEst verwendet wird, wird als Label weiterhin der Rotationswinkel des ausgewählten Teils bezüglich einer Oberflächennormale der Ablagefläche zugeordnet. Bei Verwendung einer Simulation zur Erzeugung solcher Daten, beispielsweise unter Verwendung einer Raytracer-Engine, können diese Daten zum Labeln der erfassten Bilder automatisch erzeugt werden.

Diese ganzen derart erzeugten Daten können dann verwendet werden, um beispielsweise ein Deep-Neural-Network zu trainieren, wobei beispielsweise Standardarchitekturen wie YOLO für das Modell M-Seg und ein Convolutional Neural Network für die Regression bzw. das Regressions-Modell verwendet werden können.

In einem wiederum nachfolgenden Schritt werden dann Referenzabbildungen der jeweiligen Teile in den jeweiligen stabilen Positionen erzeugt. Dies kann wiederum unter Verwendung von realen Objekten geschehen oder auch durch die genannte virtuelle Simulation erzeugt werden. Dabei hat die Verwendung realer Objekte den Nachteil, dass das Labelling manuell geschehen muss. Bei Verwendung von virtuellen 3D-Modellen können die für das Labelling notwendigen Daten automatisch erzeugt werden und das Labelling daher auch automatisch ablaufen. Weiterhin können auch die Transformationsdaten genauer ermittelt werden, wenn die Bilder aufgrund einer physikalischen Simulation mit 3D-Modellen erzeugt werden.

Die erzeugten Transformationsdaten erlauben es dann, mithilfe der vorstehend beschriebenen Verfahren im 3D-Modell eines bestimmten Teils gekennzeichnete Greifpunkte in die Koordinaten entsprechender Greifpunkte eines realen erfassten Teils zu transformieren, sodass eine Greifeinrichtung unter Verwendung dieser Koordinaten das reale Teil an den entsprechenden Greifpunkten greifen kann.

Nachfolgend wird die vorliegende Erfindung beispielhaft mit Bezug auf die beigefügten Figuren näher erläutert.

Es zeigen:
Figur 1: Beispiel für ein System zum Greifen eines Gegenstands;
Figur 2: Beispiel für ein 3D-Modell mit Greifpunkten und dargestellten stabilen Lagen;
Figur 3: Verfahrensbeispiele zur Ermittlung von stabilen Lagen eines Gegenstands;
Figur 4: Verfahrensbeispiele zum Training eines ML-Modells;
Figur 5: Verfahrensbeispiele zum Erzeugen von Trainingsdaten für ein ML-Modell;
Figur 6: Beispiel für ein Verfahren zum Greifen eines Gegenstands;
Figur 7: Beispiel für ein erfasstes Kamerabild von Gegenständen inklusive einer Darstellung der zugehörigen 3D-Modelle;
Figur 8: ein zweites Beispiel für ein System zum Greifen eines Gegenstands;
Figur 9: ein drittes Beispiel für ein System zum Greifen eines Gegenstands.

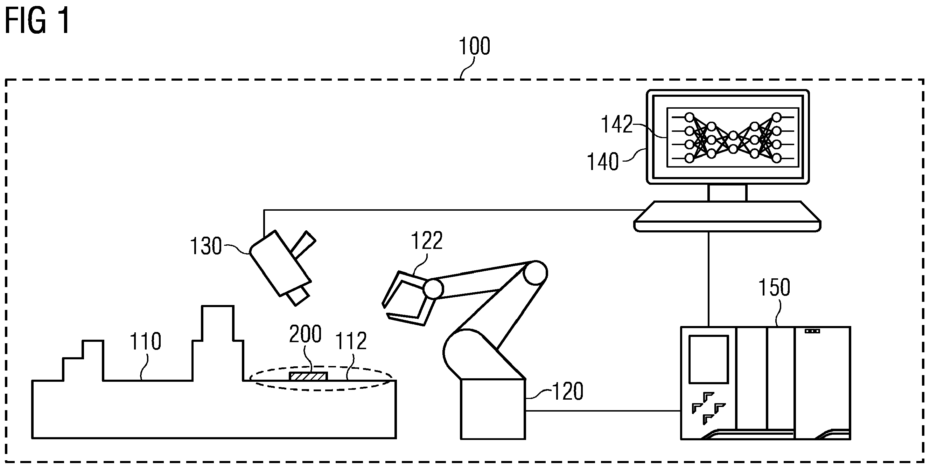

Figur 1 zeigt ein Greifsystem 100 als ein Ausführungsbeispiel für ein System gemäß der vorliegenden Beschreibung. Dieses beispielhafte Greifsystem 100 ist zur Erkennung, Auswahl und dem Greifen und Transport von Gegenständen 200 auf einer Transporteinrichtung 110 ausgebildet und eingerichtet.

Dazu ist in Figur 1 ein quaderförmiges Greifobjekt 200 dargestellt, welches innerhalb einer Transporteinrichtung 110 zu einer ebenen Ablagefläche 112 transportiert und dort abgelegt wird. Weiterhin ist eine Kamera 130 zur Erfassung der Ablagefläche 112 mit dem Greifobjekt 200 vorgesehen, welche mit einem Industrie-PC 140 verbunden ist. Der Industrie-PC 140 umfasst dabei eine Bildauswerte-Software, welche ein neuronales Netz 142 umfasst. Unter Verwendung dieser Bildauswerte-Software mit dem neuronalen Netz 142 werden die von der Kamera 130 erfassten Bilder derart ausgewertet, dass das Greifobjekt 200 sowie weitere mögliche Objekte erkannt werden und mit einem nachfolgend näher beschriebenen Verfahren Daten für Greifpunkte zum Greifen dieses Objekts ermittelt werden.

Diese Daten für die Greifpunkte zum Greifen des Objekts 200 werden dann vom Industrie-PC zu einer modularen speicherprogrammierbaren Steuerung (SPS) 150 übermittelt. Dort werden diese Daten weiterverarbeitet und dann an einen Roboter 120 mit einem Greifer 122 übermittelt. Der Roboter 120 steuert seinen Greifer 122 dann unter Verwendung dieser Daten derart an, dass der Greifer 122 das Objekt 200 an den dafür vorgesehenen Greifpunkten greift und zu einem weiteren, nicht in Figur 1 dargestellten Produktionsschritt transportiert.

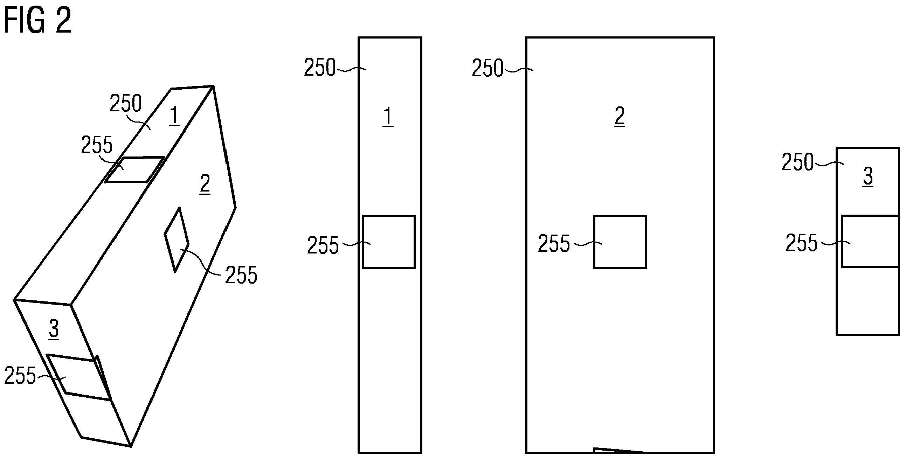

Figur 2 zeigt ein 3D-Modell 250 des quaderförmigen Greifobjekts 200. Dabei ist das 3D-Modell 250 des quaderförmigen Greifobjekts 200 in Figur 2 sowohl in perspektivische Ansicht (ganz links in Figur 2) als auch in seinen drei stabilen Lagen gemäß der vorliegenden Beschreibung dargestellt. In Figur 2 sind weiterhin drei der sechs Seiten des 3D-Modells 250 des Quaders 200 mit entsprechenden Ziffern gekennzeichnet. Die stabilen Lagen 1, 2 und 3 des 3D-Modells 250 sind dabei jeweils in einer Ansicht von oben dargestellt.

Weiterhin sind im 3D-Modell 250 jeweils zum Greifen des entsprechenden Gegenstands vorgesehene Greifpunkte 255 als schwarze Quadrate dargestellt. Dabei sind die Greifpunkte 255 solche Punkte, an denen vorteilhafterweise ein entsprechender Quader 200 von einer Greifeinrichtung 120, 122 gegriffen werden kann. Das 3D-Modell 250 wurde dabei von einem entsprechenden 3D-CAD-Programm erstellt. Innerhalb dieses Programms wurden die entsprechenden Modell-Greifpunkte 255 im 3D-Modell 250 gekennzeichnet.

Die in Figur 2 dargestellte "Stabile Lage 1" zeigt eine Lage des 3D-Modells 250, bei welcher dieses auf der schmalen langen Seite zu liegen kommt und die dazu parallele schmale lange Seite, die in Figur 2 mit einer Ziffer 1 gekennzeichnet ist, nach oben zeigt. Bei der in Figur 2 dargestellten "Stabilen Lage 2" zeigt die große lange Seite, die in Figur 2 mit einer Ziffer 2 gekennzeichnet ist, nach oben. Entsprechend zeigt die in Figur 2 dargestellte "stabile Lage 3" eine Lage, bei welcher die kurze schmale Seite des 3D-Modells 250, die in Figur 2 mit einer Ziffer 3 gekennzeichnet ist, nach oben.

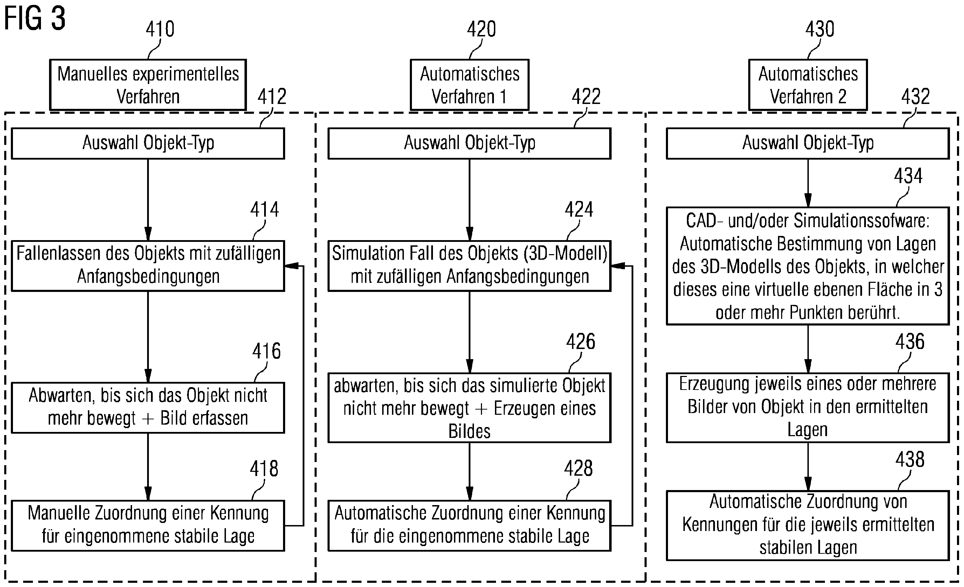

Die in Figur 2 dargestellten stabilen Lagen können nach einem Verfahren gemäß der vorliegenden Beschreibung ermittelt worden sein. Einige Beispiele für ein solches Verfahren sind im Zusammenhang mit der nachfolgenden Figur 3 näher erläutert. Figur 3 zeigt drei Beispielhafte Verfahren 410, 420, 430 für die Ermittlung von ein oder mehreren stabilen Lagen eines Objekts bzw. Gegenstands.

In einem ersten, manuellen Verfahren 410 erfolgt in einem ersten Schritt 412 die Auswahl eines bestimmten Objekttyps, für welches ein oder mehrere stabile Lagen ermittelt werden sollen.

In einem nächsten Schritt 414 wird dieses Objekt mit zufälligen Anfangsbedingungen auf eine ebene Fläche fallen gelassen. Die zufälligen Anfangsbedingungen umfassen dabei eine zufällig ermittelte Höhe über der ebenen Fläche sowie eine in Richtung und Geschwindigkeit beliebige Anfangsgeschwindigkeit für das ausgewählte Objekt.

Danach wird in einem Schritt 416 abgewartet, bis sich das fallengelassene Objekt nicht mehr bewegt. Ist dieses zur Ruhe gekommen, wird, beispielsweise mit einer Kamera, ein Bild des Objekts auf der ebenen Fläche erfasst.

In einem nächsten Schritt 418 wird dann die vom Objekt eingenommene stabile Position auf der ebenen Fläche identifiziert und eine für die eingenommene stabile Position eindeutige Kennung ermittelt. Diese für die eingenommene stabile Position eindeutige Kennung wird dann dem erfassten Bild zugeordnet.

Eine auf diese Weise ermittelte Kombination eines erfassten Bilds mit einer eindeutigen Kennung für die auf dem Bild durch das Objekt eingenommene stabile Lage kann dann beispielsweise für spätere vergleichbare Messungen herangezogen werden, um entsprechend eindeutige Kennungen stabilen Positionen zuzuordnen. So kann beispielsweise mithilfe derartiger Bild-Kennungs-Kombinationen eine Datenbank bezüglich stabiler Lagen von Objekten aufgebaut werden.

Weiterhin kann eine derartige Bild-Kennungs-Kombination zum Training eines ML-Modells gemäß der vorliegenden Beschreibung verwendet werden.

In einer weiteren vorteilhaften Ausgestaltung wird nachfolgend Verfahrensschritt 418 wiederum Verfahrensschritt 414 ausgeführt, beispielsweise mit demselben Objekt und anderen Anfangsbedingungen. Auf diese Weise wird dann wiederum eine neue Bild-Kennungs-Kombination erzeugt mit der dann wie vorstehend bereits beschrieben umgegangen werden kann. Dies ist in Figur 3 mit einem Pfeil zwischen den Verfahrensschritten 418 und 414 gekennzeichnet.

Auf diese Weise kann das Verfahren so lang durchgeführt werden, bis beispielsweise für eine Datenbank oder auch für ein Training eines entsprechenden ML-Modells genügend Bild-Kennungs-Kombinationen vorhanden sind.

Dies kann beispielsweise der Fall sein, wenn für jedes der möglichen Objekte und jede der möglichen stabilen Lagen derartiger Objekte genügend Bild-Kennungs-Kombinationen vorliegen.

Figur 3 zeigt weiterhin ein erstes automatisches Verfahren 420 ebenfalls zur Ermittlung von stabilen Lagen eines oder mehrerer Objekte.

Auch hierbei wird in einem ersten Schritt 422 ein Objekt ausgewählt, für welches entsprechend stabile Lagen bestimmt werden sollen. Zu diesem Objekt wird dann ein entsprechendes 3D-Modell ausgewählt. Derartige 3D-Modelle können beispielsweise mit entsprechenden 3D-CAD Programmen erstellt werden bzw. erstellt worden sein.

In einem nächsten Schritt 424 wird dann der Fall eines solchen Objekts auf eine ebene Fläche unter Verwendung des 3D-Modells des Objekts auf eine virtuelle Fläche unter Verwendung einer Simulationsumgebung mit einer physikalischen Simulation simuliert (beispielsweise mit einer sogenannten "Game-Engine"). Dabei können die Anfangsbedingungen beispielsweise bezüglich Geschwindigkeit und Richtung zufällig gewählt werden.

Nachfolgend wird in einem Schritt 426 die Simulation so lange fortgeführt, bis sich das simulierte Objekt im Rahmen der normalen Messgenauigkeit nicht mehr bewegt. Dann wird mit Hilfe der Simulationsumgebung ein Bild des auf der virtuellen ebenen Fläche zur Ruhe gekommenen 3D-Modells des Gegenstands erzeugt. Dabei wird das Bild auf eine Weise erzeugt, dass es einer Kameraaufnahme eines dem 3D-Modell entsprechenden realen Objekts auf einer der virtuellen Fläche entsprechenden realen ebenen Fläche entspricht.

Danach wird im nächsten Schritt 428 diesem erstellten bzw. erzeugten Bild eine eindeutige Kennung für die durch das 3D-Modell auf dem Bild eingenommene stabile Lage zugeordnet.

Wie im vorstehenden Beispiel kann diese Bild-Kennungs-Kombination dann zum Aufbau einer entsprechenden Datenbank bzw. zum Training eines entsprechenden ML-Modells herangezogen werden.

In einer vorteilhaften Ausgestaltung kann das genannte Verfahren dann mehrfach ausgeführt werden, indem dem Verfahrensschritt 428 dann erneut der Verfahrensschritt 424 nachfolgt. In diesem nachfolgenden Schritt 424 wird dann der Fall eines 3D-Modells beispielsweise mit anderen Anfangsbedingungen simuliert. Dies ist in Figur 3 durch einen entsprechenden Verbindungspfeil zwischen Verfahrensschritt 428 und Verfahrensschritt 424 dargestellt.

Auf diese Weise können wiederum, wie vorstehend bereits beschrieben, so viele Bild-Kennungs-Kombinationen erzeugt werden, wie sie zum Aufbau einer entsprechenden Datenbank bzw. zum Training eines entsprechenden ML-Modells notwendig sind.

Weiterhin zeigt Figur 3 ein zweites automatisches Verfahren 430 zur Ermittlung von stabilen Objektlagen. Auch in diesem Fall wird in einem ersten Schritt 432 ein Objekt ausgewählt, für welches nachfolgend stabile Objektlagen bestimmt werden.

Dieses zweite automatische Verfahren arbeitet wiederum unter Verwendung eines 3D-Modells des ausgewählten Objekttyps. Dabei werden in einer nächsten Verfahrensschritt 434 in einer entsprechenden Simulations- oder CAD-Software diejenigen Lagen des ausgewählten 3D-Modells auf einer virtuellen Fläche ermittelt, bei welchen das 3D-Modell die virtuelle ebene Fläche in drei oder mehr Punkten berührt, ohne dass das 3D-Modell diese ebene Fläche in weiteren Punkten durchdringt.

Von jeder dieser ermittelten Lagen des 3D-Modells auf der virtuellen ebenen Fläche wird dann in einem nächsten Schritt 436, vergleichbar mit dem ersten automatischen Verfahren 420, ein oder mehrere Bilder des 3D-Modells auf der virtuellen ebenen Fläche erzeugt. Dabei können, bei mehreren Bildern, für jedes der Bilder andere virtuelle Kamerapositionen herangezogen werden.

In einem nächsten Verfahrensschritt 438 wird dann den entsprechenden erstellten Bildern jeweils eine eindeutige Kennung für die durch das Objekt auf den jeweiligen Bildern eingenommene stabile Lage zugeordnet.

Diese Kennungs-Bild-Kombinationen können dann wiederum zum Aufbau einer entsprechenden Datenbank für stabile Lagen von Objekten und/oder zum Training von einem oder mehreren entsprechenden ML-Modellen herangezogen werden.

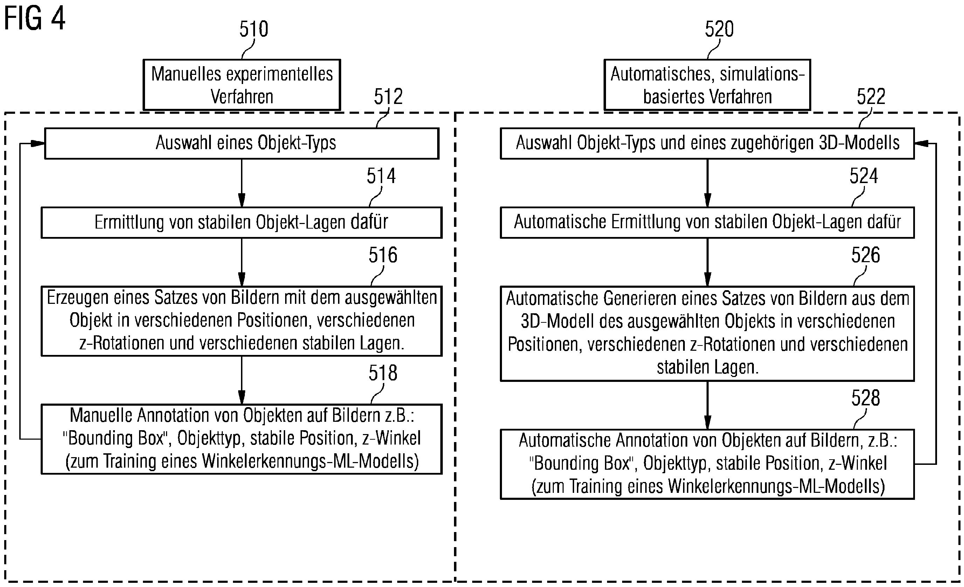

Figur 4 zeigt zwei Beispiele für Verfahren 510, 520 zum Erzeugen von Trainingsdaten für ein Erkennungs-ML-Modell und/oder ein Winkelerkennungs-ML-Modell.

Dabei ist das in Figur 4 links dargestellte erste Verfahren 510 zur manuellen bzw. teilautomatisierten Ermittlung von Trainingsdaten für ein Erkennungs-ML-Modell und/oder ein Winkelerkennungs-ML-Modell vorgesehen. Dabei wird in einem ersten Schritt 512 ein bestimmter Objekt-Typ ausgewählt, für den entsprechende Trainingsdaten erzeugt werden sollen.

In einem weiteren Schritt 514 werden stabile Objekt-Lagen für diesen Objekttyp auf einer ebenen Fläche ermittelt. Dabei können beispielsweise Verfahren gemäß der vorliegenden Beschreibung verwendet werden.

In einem nachfolgenden Arbeitsschritt 516 wird eine Mehrzahl von Bildern unter Verwendung des ausgewählten Objekts in verschiedenen Positionen, verschiedenen stabilen Lagen und verschiedenen Rotationswinkeln um eine oberflächennormale der ebenen Fläche erzeugt oder z.B. aus einer Datenbank oder Bildersammlung ausgewählt.

In einem nachfolgenden Arbeitsschritt 518 werden den jeweiligen Bildern Kennungsdaten für das Objekt zugeordnet, beispielsweise Daten bezüglich eines virtuellen Rahmens um das Objekt, ein Objekttyp, eine Kennung für die eingenommene stabile Lage und/oder ein Ort. Werden Trainingsdaten für ein Winkelerkennungs-ML-Modell erzeugt, umfassen die Kennungsdaten weiterhin auch noch einen Rotationswinkel.

Danach wird werden dieselben Verfahrensschritte beginnen mit Verfahrensschritt 512 wiederum mit einem weiteren Objekt-Typ ausgeführt. Diese Schleife wird so lange wiederholt, bis Trainingsdaten für all jene Objekte erzeugt wurden, welche für eine Anwendung des entsprechenden ML-Modells benötigt werden.

Das auf der rechten Seite von Figur 4 dargestellte automatische, simulationsbasierte Verfahren 520 beginnt wiederum in einem ersten Verfahrensschritt 522 mit einer Auswahl eines Objekt-Typs und einem entsprechend zugehörigen 3D-Modell für diesen Objekttyp. Dabei kann Das 3D-Modell beispielsweise gemäß der vorliegenden Beschreibung ausgebildet und eingerichtet sein.

Danach werden im nächsten Verfahrensschritt 524 wiederum die stabilen Objekt-Lagen unter Verwendung des 3D-Modells des ausgewählten Objekttyps automatisch ermittelt. Diese automatische Ermittlung kann beispielsweise gemäß der vorliegenden Beschreibung erfolgen.

In einem nächsten Verfahrensschritt 526 wird automatisch ein Satz von Bildern unter Verwendung des 3D-Modells des ausgewählten Objekttyps in verschiedenen Positionen, stabilen Lagen und Rotationswinkeln erzeugt. Die Erzeugung dieser Bilder kann beispielsweise wiederum gemäß der vorliegenden Beschreibung erfolgen, beispielsweise unter Verwendung einer entsprechenden Raytracer-Engine.

In einem nächsten Verfahrensschritt 528 werden die erzeugten Bilder dann mit entsprechenden Kenndaten automatisch annotiert bzw. gelabelt. Derartige Kenndaten sind beispielsweise Informationen bezüglich eines virtuellen Rahmens um das dargestellte Objekt, einen Objekttyp, eine Kennung bezüglich einer stabilen Lage des Objekts und/oder einer Position des Objekts. Sind die Trainingsdaten zum Training eines Winkelerkennungs-ML-Modells vorgesehen, dann umfassen die Kenndaten weiterhin einen Rotationswinkel. Die genannten Kenndaten können automatisch annotiert bzw. gelabelt werden, da durch die virtuelle Erzeugung der Bilder mithilfe einer Simulationsumgebung und einer entsprechenden Raytracer-Engine diese Daten bereits beim Erzeugen des Bilds bekannt sind.

Danach werden die Verfahrensschritte, beginnend mit dem Verfahrensschritt 522 für einen weiteren Objekttyp ausgeführt. Diese Schleife wird so lange durchgeführt, bis Trainingsdaten für all jene Objekte erzeugt wurden, welche für eine Anwendung des entsprechenden ML-Modells benötigt werden.

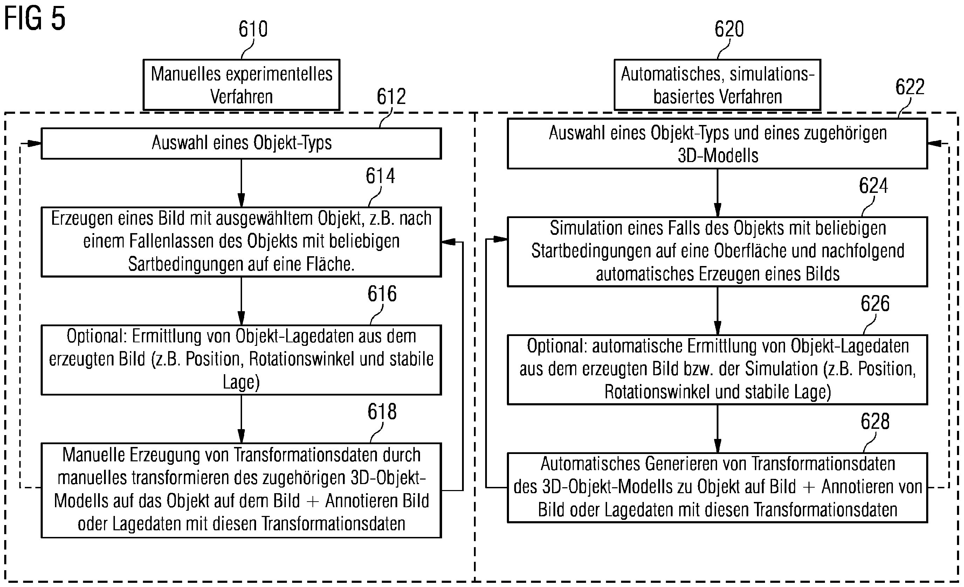

In Figur 5 sind zwei Verfahren 610, 620 dargestellt, welche Beispiele für Verfahren zur Erzeugung von Trainingsdaten für ein Transformation-ML-Modell sind.

Auf der linken Seite von Figur 5 ist ein erstes manuelles Verfahren 610 dargestellt.

In einem ersten Arbeitsschritt 612 wird dabei wiederum ein bestimmter Objekttyp ausgewählt, für welchen dann entsprechende Trainingsdaten erzeugt werden.

In einem zweiten Arbeitsschritts 614 wird dann ein Bild unter Verwendung des ausgewählten Objekttyps erzeugt, z.B. nachdem das ausgewählte Objekt mit beliebigen Anfangsbedingungen (z.B. bezüglich Höhe und Start-Geschwindigkeitsvektor) auf eine ebene Fläche fallen gelassen wurde.

In einem nächsten, optionalen Schritt 616 werden dann Objekt-Lagedaten aus dem erzeugten Bild ermittelt. Solche Objekt-Lagedaten können beispielsweise eine Position des Objekts eine Kennung für das Objekt, Informationen bezüglich eines virtuellen Begrenzungsrahmens um das Objekt, ein Rotationswinkel und/oder eine eingenommene stabile Lage sein bzw. umfassen.

Nachfolgend werden dann in einem nächsten Schritt 618 Transformationsdaten zur Transformation eines 3D-Modells des ausgewählten Objekts in die Lage des Modells auf dem erzeugten Bild bestimmt. Dies kann beispielsweise derart erreicht werden, indem beispielsweise auf einem Computerbildschirm das erfasste Bild mit einer Darstellung des 3D-Modells überlagert wird und durch manuelle Transformationsaktionen eines Benutzers das 3D-Modell Bild des Objekts so transformiert bzw. gedreht und verschoben und eskaliert wird, dass es mit den auf dem erzeugten Bild dargestellten Objekt übereinstimmt. Aus den dabei verwendeten Transformation-Operationen können die gewünschten Transformationsdaten dann auf dem Fachmann bekannte Weise ermittelt werden.

Danach werden diese Transformationsdaten dann beispielsweise dem erzeugten Bild oder auch den ermittelten Objekt-Lagedaten zugeordnet. Diese annotierten oder gelabelten Bilder bzw. annotierten oder gelabelten Lagedaten können dann zum Training eines entsprechenden Transformation-ML-Modells herangezogen werden.

Nachfolgend werden die Verfahrensschritte beginnend mit Verfahrensschritts 614 so lange wiederholt, bis für den ausgewählten Objekttyp genügend Trainingsdaten erzeugt wurden. Diese Schleife ist durch einen entsprechenden Pfeil an der rechten Seite des dargestellten manuellen experimentellen Verfahrens 610 symbolisiert.

Wurden genügend Trainingsdaten für ein bestimmtes Objekt erzeugt, wird nachfolgend dem letztausgeführten Verfahrensschritt 618 zum Annotieren eines Bilds bzw. von Lagedaten das manuelle Verfahren 610 beim ersten Verfahrensschritt 612 zur Auswahl eines neuen Objekttyps wieder begonnen, wonach entsprechende Trainingsdaten für diesen weiteren Objekttyp ermittelt werden. Diese Schleife ist durch einen gestrichelten Pfeil an der linken Seite des in Figur 5 dargestellten manuellen Verfahrens 610 symbolisiert.

Der vorstehend dargestellte Ablauf des manuellen Verfahren 610 wird solange ausgeführt, bis genügend Trainingsdaten für alle relevanten Objekttypen ermittelt wurden.

Auf der rechten Seite von Figur 5 ist ein beispielhaftes automatisches Verfahren 620 dargestellt, mit welchem sich Trainingsdaten für ein Transformations-ML-Modell automatisiert und simulationsbasiert erzeugen lassen.

In einem ersten Verfahrensschritt 622 wird auch hier ein bestimmter Objekttyp und ein entsprechendes 3D-Modell dafür ermittelt.

Danach wird in einem nächsten Verfahrensschritt 624 automatisch ein Bild des ausgewählten 3D-Modells in beliebiger Position, mit beliebigem Rotationswinkel und in beliebiger stabiler Lage erzeugt. Dies kann beispielsweise vermittels einer physikalischen Simulation erfolgen, bei welcher der Fall eines entsprechenden Objekts mit beliebigen Startbedingungen (z.B. Bezüglich Höhe und Geschwindigkeitsvektor) auf eine ebene Oberfläche simuliert wird, und dann mithilfe einer entsprechenden Raytracer-Engine ein Bild des Gegenstands erzeugt wird, nachdem dieser in der Simulation wieder zur Ruhe gekommen ist. Diese Erzeugung eines Bilds kann beispielsweise gemäß der vorliegenden Beschreibung ausgebildet und eingerichtet sein.

Bei bekannten stabilen Lagen des Gegenstands können die Bilder z.B. auch erzeugt werden, indem das 3D-Modell des Gegenstands mit verschiedenen Positionen, Rotationswinkeln und stabilen Lagen jeweils auf einem Bild dargestellt bzw. gerendert wird - z.B. durch ein entsprechendes 3D-Modelling- oder 3D-CAD-Tool.

In einem nächsten optionalen Verfahrensschritt 626 werden automatisch Objekt-Lagedaten aus dem erzeugten Bild bzw. direkt aus der entsprechenden Simulationsumgebung oder dem entsprechenden 3D-Modelling- oder 3D-CAD-Tool entnommen. Solche Objekt-Lagedaten können wiederum beispielsweise eine Position, Informationen bezüglich eines virtuellen Begrenzungsrahmens um das Objekt, ein Rotationswinkel und/oder eine Kennung für eine eingenommene stabile Lage des Objekts umfassen.

In einem nachfolgenden Verfahrensschritt 628 werden dann automatisch Transformationsdaten des 3D-Modells des Objekts in das in der Simulationsumgebung befindliche Objekt bzw. das auf dem erzeugten Bild dargestellte Objekt erzeugt. Dies kann beispielsweise durch Importieren des 3D-Modells des Objekts in die Simulationsumgebung und nachfolgende automatisch ermittelte oder mittelbare Transformationsoperationen derart geschehen, dass das importierte 3D-Modell des Objekts in das auf der ebenen Oberfläche befindliche Objekt in der eingenommenen stabilen Lage überführt wird. Diese Abfolge von Transformationsoperationen können dann bereits die entsprechenden Transformationsdaten darstellen. Weiterhin kann alternativ diese Abfolge von Transformationsoperationen auf dem Fachmann bekannte Weise in die Transformationsdaten umgewandelt werden. Dann wird beispielsweise das erzeugte Bild oder die dazu ermittelten Lagedaten mit diesen entsprechenden Transformationsdaten annotiert bzw. gelabelt. Die so gelabelten Bilder bzw. Lagedaten können dann als Trainingsdaten für ein entsprechendes Transformation-ML-Modell herangezogen werden.

Wie bereits im Zusammenhang mit dem manuellen Verfahren 610 in Figur 5 erwähnt, können auch hierdurch eine erste Verfahrensschleife zurück zu Verfahrensschritts 624 erst weitere Bilder für den ausgewählten Objekttyp und damit auch weitere Trainingsdaten für diesen Objekttyp für ein Transformation-ML-Modell erzeugt werden. Diese erste Schleife ist in Figur 5 durch einen Pfeil an der linken Seite des Verfahrensablaufs des automatischen Verfahren 620 gekennzeichnet.

Wurden genügend Trainingsdaten für einen bestimmten Objekttyp erzeugt, wird in einer zweiten überlagerten Verfahrensschleife, beginnend wiederum beim ersten Verfahrensschritt 622 ein neuer Objekttyp ausgewählt und danach das vorstehend erläuterte Verfahren für diesen weiteren Objekttyp durchgeführt. Diese zweite überlagerte Verfahrensschleife ist in Figur 5 an der rechten Seite der Darstellung des automatischen Verfahren 620 durch einen entsprechenden gestrichelten Pfeil vom letzten Verfahrensschritts 628 zum ersten Verfahrensschritt 622 dargestellt.

Das gesamte automatische Verfahren 620, wie vorstehend dargestellt, wird dann so lange ausgeführt, bis für alle erforderlichen Objekttypen genügend Trainingsdaten zum Trainieren eines entsprechenden Transformation-ML-Modells zur Verfügung stehen.

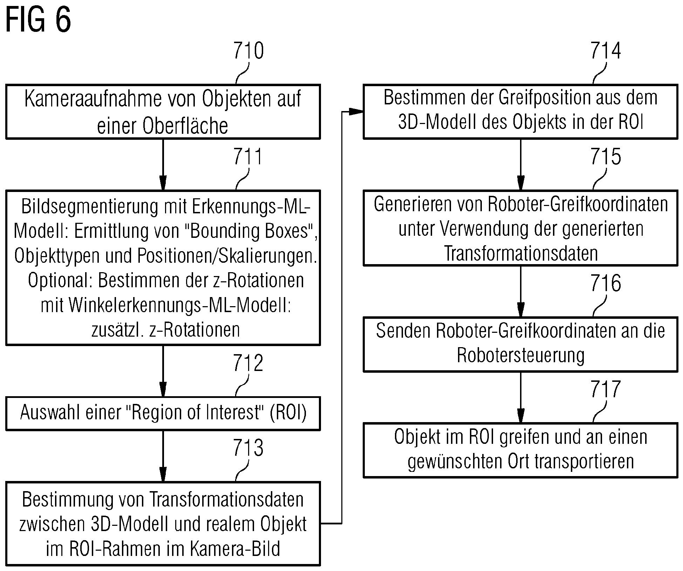

Figur 6 zeigt ein Beispiel für einen Verfahrensablauf zum Greifen eines Objekts von einer Fläche unter Verwendung eines Erkennungs-ML-Modells bzw. eines Winkelerkennungs-ML-Modells sowie eines Transformation-ML-Modells gemäß der vorliegenden Beschreibung.

Nachfolgend wird das in Figur 6 dargestellte Verfahren dabei am Beispiel des in Figur 1 dargestellten Systems näher erläutert.

In einem ersten Verfahrensschritt 710 wird von der Kamera 130 eine Kameraaufnahme des auf der Ablagefläche 112 befindlichen Quaders 200 gemacht.

Dieses Kamerabild wird im nächsten Verfahrensschritts 711 an den Industrie-PC 140 übermittelt, auf welchem eine entsprechende Bildauswerte-Software umfassend ein entsprechendes Erkennungs-ML-Modell oder auch ein entsprechendes Winkelerkennungs-ML-Modell implementiert ist. Das in Figur 1 dargestellte neuronale Netz 142 ist dabei ein Beispiel für ein solches Erkennungs-ML-Modell oder ein solches Winkelerkennungs-ML-Modell.

Im genannten Verfahrensschritt 711 wird unter Verwendung des Erkennungs-ML-Modells ein virtueller Begrenzungsrahmen (eine sogenannte "Bounding Box") um den abgebildeten Quader 200 bestimmt, sowie ein Objekttyp für den erfassten Quader 200 sowie seine Position und Skalierung auf dem aufgenommenen Bild sowie eine dabei eingenommene stabile Position bestimmt. Diese Ermittlung der genannten Parameter kann beispielsweise wie in der vorliegenden Beschreibung näher erläutert ausgebildet und eingerichtet sein. Optional kann auch ein Winkelerkennungs-ML-Modell verwendet werden, wobei dann als zusätzlicher Parameter noch ein Rotationswinkel um eine Oberflächennormale der Ablagefläche 112 ermittelt wird. Auch diese Ermittlung kann beispielsweise gemäß der vorliegenden Beschreibung ausgebildet und eingerichtet sein.

Für den Fall, das auf dem erfassten Bild mehrere Objekte dargestellt sind, wird Verfahrensschritts 711 für jedes der dargestellten Objekte durchgeführt.

In einem weiteren Verfahrensschritt 712 beispielsweise derjenige virtuelle Begrenzungsrahmen ausgewählt, in welchem sich das Objekt befindet, dass vom Roboter 120 gegriffen werden soll. Im vorliegenden Beispiel entspricht der ausgewählte Begrenzungsrahmen demjenigen um den Quader 200.

Danach werden in einem nächsten Verfahrensschritt 713 unter Verwendung eines entsprechend für diesen Anwendungsfall trainierten Transformations-ML-Modells Transformationsdaten für eine Transformation eines 3D-Modells 250 für den Quader 200 in den auf der Ablagefläche 112 befindlichen Quader 200 erzeugt. Dafür werden beispielsweise charakteristische Lagedaten des Quaders 200, wie z.B. seine Position, Informationen zum virtuellen Begrenzungsrahmen um den Quader, die eingenommene stabile Lage, ein Rotationswinkel bezüglich einer Oberflächennormale der Ablagefläche 112 oder vergleichbare Lagedaten in das Transformation-ML-Modell eingegeben. Dieses liefert dann die entsprechenden Transformationsdaten zur Transformation des 3D-Modells 250 des Quader 200 in den auf der Ablagefläche 112 befindlichen Quader 200.

Danach werden in einem nächsten Verfahrensschritts 714 Koordinaten der im 3D-Modell 250 des Quaders 200 erfassten Greifpunkte 255 bestimmt.

Danach werden die in Verfahrensschritts 713 generierten Transformationsdaten dann in einem weiteren Verfahrensschritt 715 auf die Koordinaten der Modell-Greifpunkte 255, welche in Verfahrensschritts 714 ermittelt wurden, angewendet, um daraus dann konkrete Roboter-Greifkoordinaten zum Greifen des Quaders 200 auf der Ablagefläche 112 zu bestimmen. Dabei sind die entsprechenden Roboter-Greifkoordinaten derart ausgebildet und eingerichtet, dass der Greifer 122 des Roboters 120 den Quader 200 an einem oder mehreren Greifpunkten fast, wobei diese Greifpunkte Modell-Greifpunkten 255 im 3D-Modell 250 des Quaders 200 entsprechen.

Während die Verfahrensschritte 711 bis 715 beispielsweise im Industrie-PC 140 ablaufen, werden dann die in Verfahrensschritts 715 generierten Roboter-Greifkoordinaten in einem nächsten Verfahrensschritt 716 vom Industrie-PC 140 an die SPS 150 übermittelt.

In einem abschließenden Verfahrensschritts 717 werden diese Daten nachfolgend von der SPS 150 in entsprechende Steuerdaten für den Roboter 120 umgewandelt und an den Roboter 120 übertragen. Dieser greift dann den Quader 200 an den berechneten Greifpunkten, um ihn nachfolgend an einen gewünschten Ablageort zu transportieren.

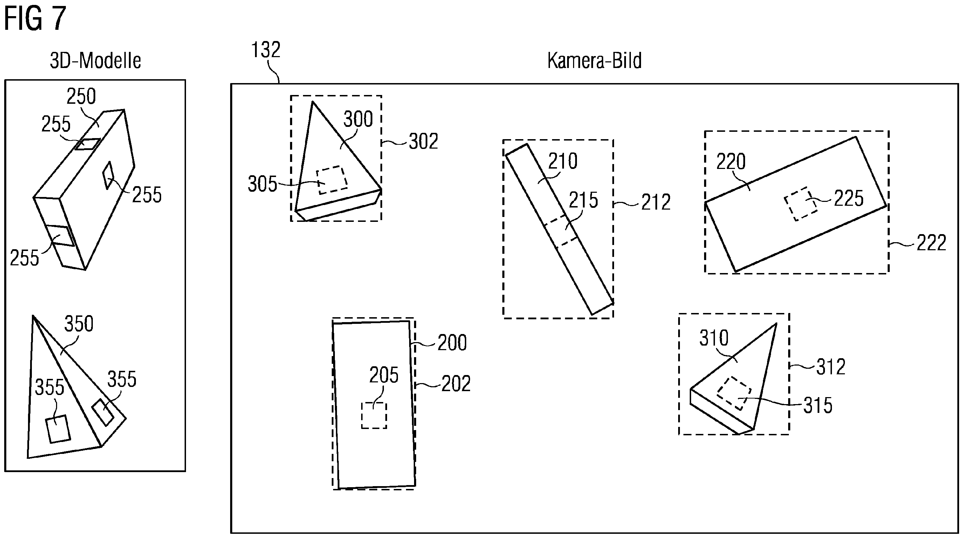

Figur 7 zeigt auf der linken Seite zwei 3D-Modelle 250, 350, wobei neben dem bereits in Figur 2 dargestellten 3D-Modell 250 des Quaders 200 weiterhin noch ein 3D-Modell 350 einer Pyramide dargestellt ist. Im 3D-Modell 250 des Quaders 200 sind wiederum entsprechende Modell-Greifpunkte 255 gekennzeichnet, welche geeignete Stellen am entsprechenden Quader 200 kennzeichnen, an welchen vorteilhafterweise ein Greifer zum Greifen des Quaders 200 ansetzen kann. Entsprechend sind im 3D-Modell 350 der Pyramide Modell-Greifpunkte 355 zum Greifen einer entsprechenden Pyramide gekennzeichnet.

Auf der rechten Seite von Figur 7 ist beispielhaft ein Kamerabild 132 dargestellt, auf welchem auf einer entsprechenden ebenen Fläche befindliche Quader 200, 210, 220 sowie Pyramiden 300, 310 erfasst wurden. Dabei entsprechen die drei dargestellten Quader 200, 210, 220 dem 3D-Modell 250 des Quaders, welcher auf der linken Seite von Figur 7 dargestellt ist. Die zwei Pyramiden 300, 310 entsprechen dem 3D-Modell 350 der Pyramide, welche auf der linken Seite von Figur 7 dargestellt ist.

Dabei befindet sich ein erster auf dem Kamerabild 132 dargestellte Quader 200 in der zweiten stabilen Lage für diesen Quader 200, wie sie im Rahmen der Erläuterungen zu Figur 2 dargestellt wurde. In dieser zweiten stabilen Lage zeigt die große lange Seite, welche in Figur 2 mit der Ziffer 2 gekennzeichnet ist, nach oben. Weiterhin ist auf den Kamerabild 122 auf dem Quader 200 ein entsprechender Greifpunkt 205 gekennzeichnet, welcher dem in Figur 2 dargestellten Modell-Greifpunkt 255 in der zweiten stabilen Lage entspricht.

Vermittels eines Verfahrens gemäß der vorliegenden Beschreibung können dann beispielsweise Transformationsdaten berechnet werden, mit welchen sich die Parameter für den entsprechenden Modell-Greifpunkt 255 in Koordinaten für den Greifpunkt 205 des Quaders 200 auf dem Kamerabild 132 umrechnen lassen. Mithilfe Diese Transformationsdaten können dann beispielsweise Steuerungsdaten für einen Roboter ermittelt werden, damit dieser beispielsweise mit einem Sauggreifer den Quader 200 am Greifpunkt 205 fassen und somit transportieren kann.

Weiterhin zeigt das Kamerabild 132 einen virtuellen Begrenzungsrahmens 202 um den dargestellten Quader 200. Mit diesem virtuellen Begrenzungsrahmen 202 kann beispielsweise eine entsprechende "Region of Interest" (ROI) für diesen Quader 200 definiert werden. Weiterhin lassen sich aus den Daten zu diesem virtuellen Begrenzungsrahmens 202 für den dargestellten Quader 200 weitere Kenngrößen für den Quader, wie beispielsweise eine Position, ein Skalierungsfaktor oder auch eine Abschätzung für einen Rotationswinkel und/oder eine stabile Lage ermitteln.

Auf vergleichbare Weise ist in Figur 7 ein zweiter Quader 210 dargestellt, welcher sich in einer ersten stabilen Lage, wie sie in Figur 2 erläutert wurde, befindet. Dabei zeigt die kurze lange Seite des Quaders 210, welche in Figur 2 mit der Ziffer 1 bezeichnet ist, nach oben. Auf dem Kamerabild 132 ist wiederum ein entsprechender Quader Greifpunkt 215 dargestellt, welcher dem Modell-Greifpunkt 255 entspricht, welche in Figur 2 auf der Abbildung der Ansicht der stabilen Lage 1 des 3D-Modells 250 des Quaders entspricht. Weiterhin ist auch hier ein virtueller Begrenzungsrahmen 212 um den zweiten Quader 210 dargestellt.

Weiterhin zeigt Figur 7 auf dem Kamerabild 132 einen dritten Quader 220, welche sich wiederum in der zweiten stabilen Lage gemäß Figur 2 befindet. Auch hier ist wieder ein entsprechender Greifpunkte 225 eingezeichnet, welcher dem in Figur 2 dargestellten Modell-Greifpunkt 255 in der zweiten stabilen Lage entspricht. Auch dem dritten Quader 220 ist ein entsprechender virtueller Begrenzungsrahmen 222 zugeordnet und auf dem Kamerabild 132 dargestellt.

Entsprechend zeigt das Kamerabild weiterhin eine erste Pyramide 300 mit einem in der entsprechenden stabilen Lage sichtbaren Greifpunkt 305, welcher einem der Pyramidenmodell-Greifpunkte 355 entspricht. Auch um diese erste Pyramide 300 ist ein entsprechender virtueller Begrenzungsrahmen 302 eingezeichnet, welcher beispielsweise zur Auswahl der Pyramide zu einem nachfolgenden Greifen am Greifpunkt 305 herangezogen werden kann.

Das Kamerabild 132 zeigt weiterhin eine zweite Pyramide 310 in einer stabilen Lage für eine derartige Pyramide 300, 310. Auch auf dieser auf dem Kamerabild 132 erfassten zweiten Pyramide 310 ist ein Greifpunkt 315 eingezeichnet, welcher einem der Pyramidenmodell-Greifpunkte 355 entspricht. Auch zu dieser zweiten Pyramide 310 ist auf dem Kamerabild 132 ein entsprechender virtueller Begrenzungsrahmen 312 eingezeichnet.

Ein derartiges Kamerabild 132 könnte beispielsweise erfasst werden, wenn sich auf der Ablagefläche 112 der Transporteinrichtung 110, wie sie in Figur 1 dargestellt ist, drei Quader 200, 210, 220 gemäß dem 3D-Modell 250 dieser Quader 200, 210, 220 befinden, sowie zwei Pyramiden 300, 310 gemäß dem 3D-Modell 350 dieser Pyramiden 300, 310.

Durch ein Bildauswerteverfahren gemäß der vorliegenden Beschreibung können dann beispielsweise die virtuellen Begrenzungsrahmen 202, 212, 222, 302, 312 ermittelt werden, sowie die jeweiligen Positionen, stabilen Lagen und Rotationswinkel der dargestellten Gegenstände 200, 210, 220, 300, 310. Dann kann beispielsweise der erste Quader 200 in einem entsprechenden Auswahlschritt ausgewählt werden.

Mittels eines Verfahrens gemäß der vorliegenden Beschreibung können dann aus den ermittelten Positionsdaten und Parametern des ersten Quaders 200 auf dem Kamerabild 132 Transformationsdaten ermittelt werden, mit welchen sich das 3D-Modell 250 des Quaders 200 in den auf dem Kamerabild 132 befindlichen Quader in der Realität transformieren lässt. Diese Transformationsdaten können dann angewendet werden, um die Quadermodell-Greifpunkte 255 in Koordinaten der Greifpunkte 205 des Quaders 200 auf dem Kamerabild 132 umzurechnen. Unter Verwendung dieser Koordinaten für die Greifpunkte 205 des ausgewählten Quaders 200 können dann Roboterdaten zur Ansteuerung eines Roboters, der beispielsweise einen Sauggreifer aufweist, ermittelt werden. Mit diesem lässt sich dann der Quader 200 am Quader-Greifpunkte 205 fassen und transportieren.

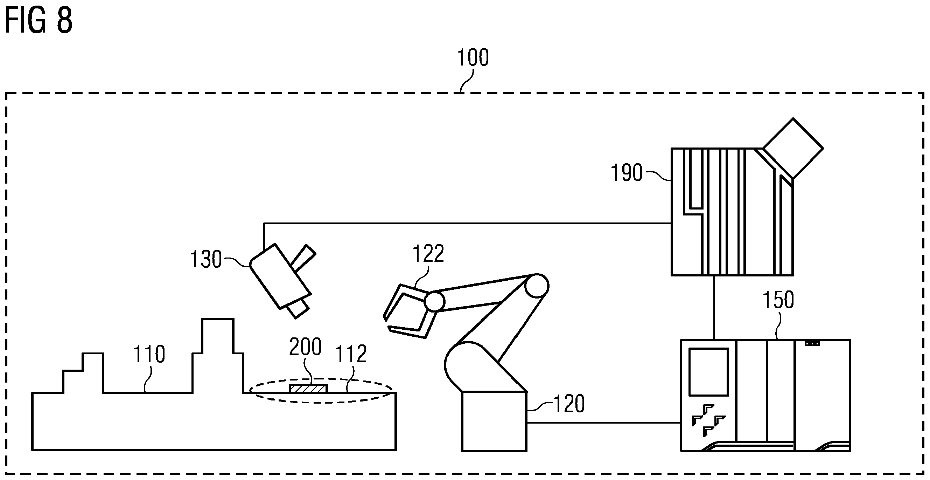

Figur 8 zeigt eine Abwandlung des bereits in Figur 1 dargestellten Greifsystems 100. Im in Figur 8 dargestellten Greifsystem 100 ist dabei der in Figur 1 dargestellte Industrie-PC 140 zur Bildauswertung durch ein Edge-Device 190 ersetzt, welches ebenfalls zumindest unter anderen zur Auswertung von Bildern der Kamera 130 ausgebildet und eingerichtet ist. Dabei kann das Edge-Device beispielsweise gemäß der vorliegenden Beschreibung ausgebildet und eingerichtet sein und beispielsweise neben der Kopplung an die SPS 150 auch noch mit einer nicht in Figur 8 dargestellten Cloud verbunden sein. Dabei kann weiterhin vorgesehen sein, dass das Bildauswerteverfahren zur Auswertung der von der Kamera 130 erfassten Bilder, oder zumindest Teile davon, auf dieser Cloud ablaufen.

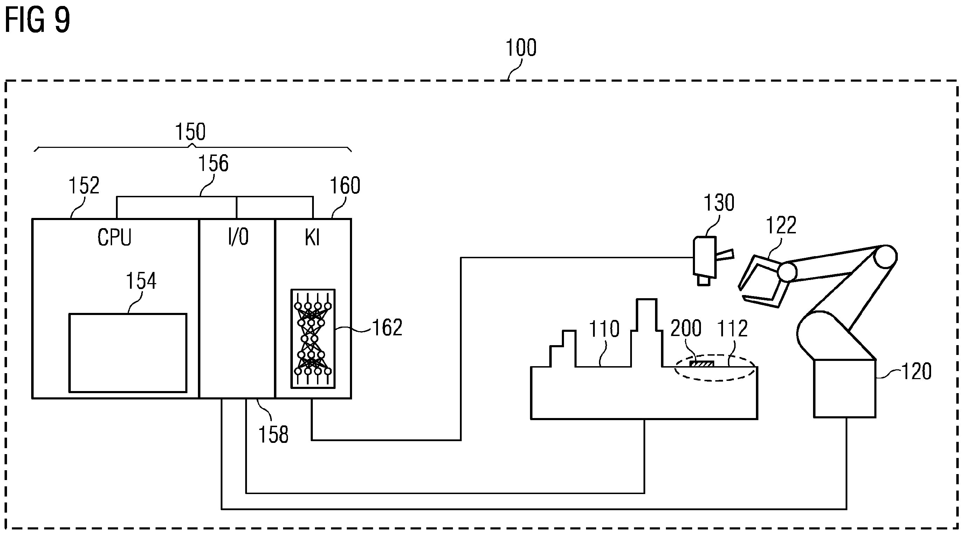

Figur 9 stellt eine weitere Abwandlung der in Figur 1 und 8 dargestellten Greifsysteme 100 dar, wobei im in Figur 9 dargestellten Greifsystem 100 die Auswertung der von der Kamera 130 erfassten Bilder in der SPS 150 erfolgen. Dazu umfasst die SPS 150 eine zentrale Steuerungsbaugruppe 152, welche eine Ablaufumgebung 154 zum Ablauf eines entsprechenden Steuerprogramms, unter anderem zur Ansteuerung der Transporteinrichtung 110 sowie des Roboters 120, aufweist. Weiterhin umfasst die SPS 150 eine Eingabe-Ausgabe-Baugruppe 158, über welche die Kommunikation der SPS 150 mit der Transporteinrichtung 110 sowie den Roboter 120 erfolgt. Die SPS 150 umfasst weiterhin ein Funktionsmodul 160 zur zum Ablauf eines Bildauswerteverfahrens zur Auswertung von Bildern der Kamera 130, wobei das Funktionsmodul 160 ein neuronales Netz 162 umfasst, welches ein Ausführungsbeispiel beispielsweise für ein Erkennungs-ML-Modell gemäß der vorliegenden Beschreibung, ein Winkelerkennungs-ML Modell gemäß der vorliegenden Beschreibung und/oder ein Transformation-ML-Modell gemäß der vorliegenden Beschreibung darstellt.

Dabei sind das Zentralmodul 152, dass Eingabe-Ausgabe-Modul 158 sowie das Funktionsmodul 160 der SPS 150 über einen internen Rückwandbus 156 miteinander gekoppelt. Die Kommunikation zwischen diesen Modulen 152, 158, 160, erfolgt beispielsweise über diesen Rückwandbus 156.

Dabei kann die SPS 150 beispielsweise derart ausgebildet und eingerichtet sein, das im Rahmen eines Verfahrens gemäß der vorliegenden Beschreibung alle diejenigen Arbeitsschritte, welche ein ML-Modell verwenden, im Funktionsmodul 160 der SPS 150 ablaufen, während alle anderen Arbeitsschritte im Rahmen des genannten Verfahrens durch ein in der Ablaufumgebung 154 des Zentralmoduls 152 ablaufenden Steuerprogramm ausgeführt werden.

Alternativ kann die SPS 150 beispielsweise auch derart ausgebildet und eingerichtet sein, dass im Rahmen eines Verfahrens gemäß der vorliegenden Beschreibung alle Arbeitsschritte, die im Zusammenhang mit der Auswertung von Bildern stehen, insbesondere Bildern der Kamera 130, im Funktionsmodul 160 ablaufen, während die Arbeitsschritte zur Steuerung der Transporteinrichtung 110 sowie des Roboters 120 durch ein in der Ablaufumgebung 154 der zentralen Steuerungsbaugruppe 152 ablaufendes Steuerprogramm ausgeführt werden.

Auf diese Weise kann die SPS 150 sehr effektiv zum Ablauf eines Verfahrens gemäß der vorliegenden Beschreibung eingerichtet werden, da rechenintensive Spezialaufgaben, wie die Behandlung der genannten ML-Modelle oder die Auswertung von Bildern, in das spezielle Funktionsmodul 160 ausgelagert sind, und alle anderen Verfahrensschritte im Zentralmodul 152 ablaufen können.

## Patentansprüche

1. Verfahren zum Erzeugen von Trainingsdaten für ein ML-Modell (142, 162),
wobei die Trainingsdaten zum Einrichten des ML-Modells (142, 162) unter Verwendung eines maschinellen Lernverfahrens ausgebildet und eingerichtet sind,
und wobei insbesondere das ML-Modell (142, 162) zur Verwendung im Rahmen eines Verfahrens zum Ermitteln von Steuerungsdaten für eine Greifeinrichtung (120, 122) zum Greifen eines Gegenstands (200, 210, 220, 300, 310) ausgebildet und eingerichtet ist,
**gekennzeichnet durch** die Verfahrensschritte:
- Auswahl eines Gegenstands (200, 210, 220, 300, 310),
- Auswahl von Startdaten des Gegenstands (200, 210, 220, 300, 310) oberhalb einer ebenen Fläche (112),
- Erzeugen einer Fallbewegung des Gegenstands (200, 210, 220, 300, 310) in Richtung der ebenen Fläche (112) beginnend mit der Startdaten,
- Erfassen eines Bilds (132) des Gegenstands (200, 210, 220, 300, 310), nachdem eine Bewegung des Gegenstands (200, 210, 220, 300, 310) auf der ebenen Fläche (112) zum Stillstand gekommen ist,
- Zuordnung einer Kennung zu dem erfassten Bild (132), wobei die Kennung eine ID-Information für eine vom Gegenstand (200, 210, 220, 300, 310) eingenommene stabile Lage umfasst,
- Speicherung der Trainingsdaten umfassend das erfasste Bild sowie die diesem zugeordnete Kennung.

2. Verfahren zum Erzeugen von Trainingsdaten für ein ML-Modell (142, 162),
wobei die Trainingsdaten zum Einrichten des ML-Modells (142, 162) unter Verwendung eines maschinellen Lernverfahrens ausgebildet und eingerichtet sind,
und wobei insbesondere das ML-Modell (142, 162) zur Verwendung im Rahmen eines Verfahrens zum Ermitteln von Steuerungsdaten für eine Greifeinrichtung (120, 122) zum Greifen eines Gegenstands (200, 210, 220, 300, 310) ausgebildet und eingerichtet ist,
**gekennzeichnet durch** die Verfahrensschritte,
- Auswahl eines 3D-Modells eines Gegenstands (250, 350),
- Auswahl von Startdaten des 3D-Modells des Gegenstands (250, 350) oberhalb einer virtuellen ebenen Fläche,
- Simulieren einer Fallbewegung des 3D-Modells des Gegenstands (250, 350) in Richtung der virtuellen ebenen Fläche beginnend mit den Startdaten,
- Erstellen eines Bilds (132) des 3D-Modells des Gegenstands (250, 350), nachdem die simulierte Bewegung des 3D-Modells des Gegenstands (250, 350) auf der virtuellen ebenen Fläche zur Ruhe gekommen ist,
- Zuordnung einer Kennung zu dem erstellten Bild (312), wobei die Kennung eine ID-Information für eine vom 3D-Modell des Gegenstands (250, 350) eingenommene stabile Lage umfasst,
- Speicherung der Trainingsdaten umfassend das erstellte Bild sowie die diesem zugeordnete Kennung.

3. Verwendung von gemäß Anspruch 1 oder 2 erzeugten Trainingsdaten zum Training des ML-Modells (142, 162).

4. ML-Modell gemäß Anspruch 1 oder 2,
**dadurch gekennzeichnet,**
**dass** das ML-Modell (142, 162) unter Verwendung von gemäß Anspruch 1 oder 2 erzeugten Trainingsdaten trainiert wurde.

5. Verfahren zum Ermitteln von Steuerungsdaten für eine Greifeinrichtung (120, 122) unter Verwendung eines ML-Modells (142, 162) gemäß Anspruch 4,
wobei das Verfahren zum Greifen eines Gegenstands (200, 210, 220, 300, 310) ausgebildet und eingerichtet ist und die nachfolgenden Schritte umfasst:
- Erfassen eines Bilds (132) des Gegenstands (200, 210, 220, 300, 310),
- Bestimmung mindestens eines Gegenstandsparameters (202, 212, 222, 302, 312) für den erfassten Gegenstand (200, 210, 220, 300, 310),
- Ermittlung von Steuerungsdaten für eine Greifeinrichtung (120, 122) zum Greifen des Gegenstands (200, 210, 220, 300, 310) an mindestens einem Greifpunkt (205, 215, 225, 305, 315),
**dadurch gekennzeichnet,**
**dass** das Ermitteln des mindestens einen Greifpunkts (205, 215, 225, 305, 315) des Gegenstands (200, 210, 220, 300, 310) unter Verwendung des ML-Modells (142, 162) erfolgt, insbesondere, dass die Bestimmung des mindestens einen Gegenstandsparameters (202, 212, 222, 302, 312) und/oder die Ermittlung der Steuerungsdaten für die Greifeinrichtung (120, 122) unter Verwendung des ML-Modells (142, 162) erfolgt.

6. System (100) zum Greifen eines Gegenstands,
umfassend eine optische Erfassungseinrichtung (130) zur Erfassung eines Bilds (132) des Gegenstands (200, 210, 220, 300, 310),
eine Datenverarbeitungseinrichtung (140, 150, 190) zum Bestimmen mindestens eines Gegenstandsparameters (202, 212, 222, 302, 312) des Gegenstands (200, 210, 220, 300, 310) und/oder zum Ermitteln von Steuerungsdaten für eine Greifeinrichtung (120, 122) zum Greifen des Gegenstands (200, 210, 220, 300, 310),
**dadurch gekennzeichnet,**
**dass** das System (100) ein ML-Modell (142, 162) gemäß Anspruch 4 umfasst, und
**dass** das System (100) zur Durchführung eines Verfahrens gemäß Anspruch 5 unter Verwendung des ML-Modells (142, 162) ausgebildet und eingerichtet ist.

7. System gemäß Anspruch 6,
**dadurch gekennzeichnet,**
**dass** die Datenverarbeitungseinrichtung (140, 150, 190) als eine modulare Speicherprogrammierbare Steuerung (150) mit einem Zentralmodul (152) und einem weiteren Modul (160) ausgebildet und eingerichtet ist, oder eine solche Speicherprogrammierbare Steuerung (150) umfasst, und
**dass** das weitere Modul (160) das ML-Modell (142, 162) umfasst.

8. System gemäß Anspruch 6,
**dadurch gekennzeichnet,**
**dass** die Datenverarbeitungseinrichtung (140, 150, 190) ein Edge-Device (190) umfasst oder als ein Edge-Device (190) ausgebildet und eingerichtet ist,
und **dass** weiterhin das Edge-Device (190) das ML-Modell (142, 162) umfasst.
